# EUROPÄISCHE PATENTSCHRIFT

(11) **EP 3 298 446 B1**
(45) Veröffentlichungstag und Bekanntmachung des Hinweises auf die Patenterteilung: **02.07.2025**
(21) Anmeldenummer: 16727302.8
(22) Anmeldetag: 19.05.2016
(51) Int. Cl.: G02B 7/00, G01M 11/02, G03F 7/00

(54) **MESSVERFAHREN UND MESSANORDNUNG FÜR EIN ABBILDENDES OPTISCHES SYSTEM**
MEASURING METHOD AND MEASURING ARRANGEMENT FOR AN IMAGING OPTICAL SYSTEM
PROCÉDÉ DE MESURE ET ENSEMBLE DE MESURE POUR UN SYSTÈME OPTIQUE DE FORMATION D'IMAGE

(30) Priorität: 20.05.2015 DE 102015209173; 22.10.2015 DE 102015220588; 04.03.2016 DE 102016203562
(43) Veröffentlichungstag der Anmeldung: 28.03.2018
(73) Patentinhaber: Carl Zeiss SMT GmbH, 73447 Oberkochen (DE)
(72) Erfinder: WEGMANN, Ulrich, 89551 Königsbronn (DE); STIEPAN, Hans-Michael, 73430 Aalen (DE); HETZLER, Jochen, 73434 Aalen (DE)
(74) Vertreter: Zeuner Summerer Stütz
(86) Internationale Anmeldenummer: PCT/EP2016/000832
(87) Internationale Veröffentlichungsnummer: WO 2016/184571

(56) Entgegenhaltungen:
- EP-A1- 0 631 129
- DE-A1- 10 316 123
- DE-A1- 102006 014 510
- DE-A1- 19 818 341
- US-A1- 2005 105 044
- US-A1- 2006 093 793
- US-A1- 2006 146 342
- US-A1- 2011 205 514

## Beschreibung

Die vorliegende Anmeldung beansprucht die Priorität der deutschen Patentanmeldung 10 2015 209 173.2 vom 20. Mai 2015, die Priorität der deutschen Patentanmeldung 10 2015 220 588.6 vom 22. Oktober 2015 sowie die Priorität der deutschen Patentanmeldung 10 2016 203 562.2 vom 4. März 2016.

### Hintergrund der Erfindung

Die Erfindung betrifft eine Messanordnung zur Vermessung einer optischen Einheit einer Projektionsbelichtungsanlage für die Mikrolithographie Weiterhin betrifft die Erfindung eine Messvorrichtung und ein Verfahren zur interferometrischen Formvermessung optischer Oberflächen. Darüber hinaus betrifft die Erfindung ein Verfahren zum Vermessen eines Wellenfrontfehlers eines abbildenden optischen Systems einer Projektionsbelichtungsanlage. Das abbildende optische System umfasst mehrere optische Elemente zum Abbilden eines Musters aus einer Objektebene in eine Bildebene.

Eine Projektionsbelichtungsanlage dient in der Mikrolithographie zur Belichtung eines fotosensitiven Materials auf einem Wafer mit einer Abbildung von Strukturen einer Maske oder eines Retikels. Hierfür enthält die Projektionsbelichtungsanlage üblicherweise ein Beleuchtungssystem und ein Projektionsobjektiv. Das Beleuchtungssystem erzeugt eine gewünschte Strahlungsverteilung zur Beleuchtung der Strukturen der Maske, während das Projektionsobjektiv die beleuchteten Strukturen mit sehr hoher Auflösung auf das fotosensitive Material des Wafers abbildet. Um die Anforderungen an die Abbildungseigenschaften zu erfüllen, ist eine Herstellung und Positionierung der in der Projektionsbelichtungsanlage verwendeten optischen Elemente mit extrem hoher Präzision erforderlich. Dazu können derzeit bei einer Herstellung oder einer Nachjustage von Projektionsbelichtungsanlagen sowohl eine Vermessung eines kompletten abbildenden optischen Systems als auch von einzelnen optischen Elementen durchgeführt werden.

Zur Vermessung eines abbildenden optischen Systems einer Projektionsbelichtungsanlage werden insbesondere phasenschiebende Interferometrietechniken, wie etwa die Scher- bzw. Shearinginterferometrie oder die Punktbeugungsinterferometrie verwendet. In der DE 103 16 123 A1 wird eine solche Vorrichtung zur Wellenfrontvermessung eines Projektionsobjektivs für die Mikrolithographie durch Scherinterferometrie beschrieben.

Für eine präzise Formvermessung einer Oberfläche eines optischen Elements werden als interferometrische Messvorrichtung oft diffraktive optische Anordnungen als so genannte Nulloptiken verwendet. Dabei wird die Wellenfront einer Prüfwelle durch ein diffraktives Element, beispielsweise ein computergeneriertes Hologramm (CGH) an eine Sollform der Oberfläche angepasst. Abweichungen von der Sollform lassen sich durch Überlagerung der an dem optischen Element reflektierten Prüfwelle mit einer Referenzwelle bestimmen. Eine solche Messvorrichtung wird beispielsweise in der DE 10 2012 217 800 A1 beschrieben.

Die ständig steigenden Anforderungen an abbildende optische Systeme in der Mikrolithographie führen zu einer immer größeren Komplexität dieser Systeme. So wird beispielsweise in Projektionsobjektiven für die Mikrolithographie mit extrem ultravioletter Strahlung (EUV) eine zunehmende Anzahl von Spiegel eingesetzt. Wie bereits vorstehend erwähnt, lässt sich mit den oben beschriebenen Messvorrichtungen und Verfahren ein abbildendes optisches System jedoch nur als Ganzes oder jedes optisches Element einzeln vermessen. Bei einer Vermessung eines komplexen abbildenden optischen Systems als Ganzes ist es schwierig die gemessenen Abbildungsfehler einzelnen optischen Elementen zuzuordnen. Zur Einzelvermessung des optischen Elements kann eine Zerlegung des kompletten abbildenden optischen Systems notwendig sein, was wegen der zunehmenden Komplexität mit einem immer größeren Zeitaufwand verbunden ist.

### Zugrunde liegende Aufgabe

Es ist eine Aufgabe der Erfindung, eine Vorrichtung sowie ein Verfahren bereitzustellen, womit die vorgenannten Probleme gelöst werden und insbesondere die Ursache eines Wellenfrontfehlers des abbildenden optischen Systems mit hoher Genauigkeit und gleichzeitig geringem Zeitaufwand bestimmt werden kann.

### Erfindungsgemäße Lösung

Die Erfindung ist durch die Ansprüche definiert.

Gemäß einem ersten Aspekt der Erfindung wird die Aufgabe durch die nachstehende Messanordnung zur Vermessung einer optischen Einheit einer Projektionsbelichtungsanlage für die Mikrolithographie gelöst. Die Messvorrichtung enthält eine Wellenfrontmessvorrichtung, welche dazu konfiguriert ist, einen Wellenfrontfehler einer abbildenden Optik mittels einer Messstrahlung zu vermessen. Weiterhin enthält die Messanordnung mindestens ein Anpassungsmodul, welches zur derartigen Manipulation der Wellenfront der Messstrahlung konfiguriert ist, dass die Kombination aus der zu vermessenden optischen Einheit und dem mindestens einen Anpassungsmodul eine abbildende optische Anordnung bildet. Die optische Einheit kann insbesondere eines der nachstehend im Rahmen eines erfindungsgemäßen Messverfahrens beschriebenen Teilanordnungen und damit eine Teilanordnung eines abbildenden optischen Systems einer Projektionsbelichtungsanlage, wie etwa ein optisches Moduls eines Projektionsobjektivs der Projektionsbelichtungsanlage, sein. Gemäß einer Ausführungsvariante kann es sich bei der Projektionsbelichtungsanlage um eine EUV-Projektionsbelichtungsanlage handeln.

Weiterhin kann die Aufgabe gemäß dem ersten Aspekt der Erfindung durch ein Verfahren zum Vermessen einer optischen Einheit einer Projektionsbelichtungsanlage für die Mikrolithographie gelöst werden, welches umfasst: ein derartiges Anordnen mindestens eines Anpassungsmoduls an der zu vermessenden optischen Einheit, dass die Kombination aus der zu vermessenden optischen Einheit und dem mindestens einen Anpassungsmodul eine abbildende optische Anordnung bildet, sowie ein Vermessen eines Wellenfrontfehlers der aus der Kombination gebildeten abbildenden optischen Anordnung.

Gemäß einer Ausführungsform ist die zu vermessende optische Einheit als nicht-abbildende Optik konfiguriert, welche bei Einstrahlung einer ebenen oder einer sphärischen Eingangswelle mit einer Wellenlänge λ eine Ausgangswelle generiert, deren Wellenfront an mindestens einem Punkt mindestens λ, insbesondere mindestens 10 λ, von einer idealen Kugelwelle abweicht. Eine derartige optische Einheit wird in dieser Beschreibung auch als "nicht-stigmatische" Optik bezeichnet. Als abbildende optische Anordnung wird in dieser Beschreibung auch eine optische Anordnung bezeichnet, welche bei Einstrahlung einer ebenen oder einer sphärischen Eingangswelle mit einer Wellenlänge λ eine Ausgangswelle generiert, deren Wellenfront an keinem Punkt mehr als λ, insbesondere an keinem Punkt mehr als 10 λ, von einer idealen Kugelwelle abweicht.

Gemäß einer Ausführungsform der Messanordnung ist diese konfiguriert zur Vermessung der optischen Einheit in Gestalt einer nicht-abbildenden Optik, welche bei Einstrahlung einer ebenen oder einer sphärischen Eingangswelle mit einer Wellenlänge λ eine Ausgangswelle generiert, deren Wellenfront an mindestens einem Punkt mindestens λ von einer idealen Kugelwelle abweicht. Gemäß einer Ausführungsform ist die optische Einheit einem mehrere optische Elemente umfassenden abbildenden optischen System einer Projektionsbelichtungsanlage für die Mikrolithographie zugeordnet, und die optische Einheit ist durch eines der optischen Elemente des abbildenden optischen Systems oder durch eine Teilanordnung der optischen Elemente des abbildenden optischen Systems gebildet. Unter einer Teilanordnung der optischen Elemente ist eine Anordnung von optischen Elementen, d.h. von mindestens zwei optischen Elementen, zu verstehen, wobei gegenüber dem abbildenden optischen System mindestens ein optisches Element fehlt. Gemäß einer Ausführungsform weist ein abbildendes optisches System der Projektionsbelichtungsanlage eine Mehrzahl an jeweils mindestens zwei optische Elemente umfassenden optischen Modulen auf und die optische Anordnung umfasst mindestens eines der optischen Module und weniger als die Mehrzahl der optischen Module.

Gemäß einer weiteren Ausführungsform ist die optische Einheit durch eine Teilanordnung der optischen Elemente des abbildenden optischen Systems gebildet, wobei die Teilanordnung der optischen Elemente sich von mindestens einem Abschnitt des abbildenden optischen System durch das Vorliegen einer mindestens ein optisches Element betreffenden Lücke unterscheidet.

Gemäß einer weiteren Ausführungsform ist das Anpassungsmodul dazu konfiguriert, eine Schnittweite der zu vermessenden optischen Einheit zu verkürzen. Gemäß einer Ausführungsvariante bildet hier die zu vermessende optische Einheit bereits eine abbildende Optik, allerdings mit einer unhandlich großen Schnittweite bzw. Brennweite. Hier kann es sich um die objektivseitige und/oder die bildseitige Schnittweite handeln. Insbesondere ist die optische Einheit ein abbildendes optisches System, insbesondere ein Projektionsobjektiv einer Projektionsbelichtungsanlage für die Mikrolithographie, jedoch mit einer großen Schnittweite. Die Anordnung aus optischer Einheit und Anpassungsmodul bildet gemäß der genannten Ausführungsform eine abbildende optische Anordnung mit einer gegenüber der optischen Einheit verkürzten Schnittweite.

Gemäß einer weiteren Ausführungsform weist die Messanordung weiterhin eine die optische Funktion der zu vermessenden optischen Einheit aufweisende Kalibriereinheit auf, welche dazu konfiguriert ist, vor der Vermessung der optischen Einheit das mindestens eine Anpassungsmodul durch Bestimmung eines Wellenfrontfehlers einer das mindestens eine Anpassungsmodul sowie die Kalibriereinheit umfassenden Anordnung zu kalibrieren. Die Kalibriereinheit kann ein oder mehrere Kalibriermodule umfassen. So kann in einem Fall, in dem die zu vermessende optische Einheit eine Lücke aufweist, die Kalibriereinheit ein die Funktion des vor der Lücke angeordneten Abschnitts der optischen Einheit aufweisendes erstes Kalibriermodul sowie ein die Funktion des nach der Lücke angeordneten Abschnitts der optischen Einheit aufweisendes zweites Kalibriermodul umfassen. Gemäß einer Ausführungsvariante umfasst die Kalibriereinheit ein oder mehrere diffraktive Strukturmuster zur Manipulation der Messstrahlung.

Die Wellenfrontmessvorrichtung sowie das Anpassungsmodul der Messanordnung können entsprechend der nachstehend mit Bezug auf das Verfahren zum Vermessen eine Wellenfrontfehlers gemäß dem ersten Aspekt der Erfindung beschriebenen Ausführungsvarianten einer Wellenfrontmessvorrichtung bzw. eines Anpassungsmoduls ausgeführt sein.

Durch das Vorsehen des genannten Anpassungsmoduls ermöglicht die erfindungsgemäße Messanordnung sowie das erfindungsgemäße Messverfahren eine separate Vermessung einzelner optischer Module eines abbildenden optischen Systems auch in Fällen, in denen die optischen Module keine abbildende Optiken sind. Dies ermöglicht die Ursachenbestimmung eines Wellenfrontfehlers des abbildenden optischen Systems mit hoher Genauigkeit und mit im Vergleich zu einer Einzelvermessung von ggf. in dem optischen Modul enthaltenen optischen Elementen geringerem Zeitaufwand. Weiterhin ermöglicht die separate Vermessung einzelner optischer Module eine der Vermessung des gesamten abbildenden optischen Systems zeitlich vorgelagerte Ursachenbestimmung eines Wellenfrontfehlers.

Gemäß einer Ausführungsform der Messanordnung bzw. des nachstehend beschriebenen Messverfahrens nach der Erfindung ist das Anpassungsmodul im Strahlengang der Wellenfrontmessvorrichtung vor der zu vermessenden optischen Einheit angeordnet. Bei einer alternativen Ausführungsform ist das Anpassungsmodul im Strahlengang der Wellenfrontmessvorrichtung nach der zu vermessenden optischen Einheit angeordnet.

Gemäß einer weiteren Ausführungsform umfasst das mindestens eine Anpassungsmodul ein eingangsseitiges Anpassungsmodul zur Manipulation der Messstrahlung, welches in einem Strahlengang der Messstrahlung vor der zu vermessenden optischen Einheit angeordnet ist, sowie ein ausgangsseitiges Anpassungsmodul zur Manipulation der Messstrahlung, welches im Strahlengang des Messstrahlung nach der zu vermessenden optischen Einheit angeordnet ist. Beide Anpassungsmodule enthalten mindestens ein optisches Element. Die optischen Elemente der Anpassungsmodule sind beispielsweise derart ausgebildet und angeordnet, dass sie zusammen mit der zu vermessenden optischen Einheit eine abbildende optische Anordnung bilden. Gemäß einer Ausführungsform der Messanordnung sind die Anpassungsmodule derart konfiguriert, dass die optische Anordnung in ihrer optischen Wirkung einem zu vermessenden abbildenden optischen System entspricht, wobei die optische Einheit eines mehrerer optischer Module des zu vermessenden optischen Systems ist. Bei einer alternativen Ausführungsform kann die optische Anordnung auch andere Abbildungseigenschaften, insbesondere eine andere Brennweite oder einen anderen Abbildungsmaßstab aufweisen.

Gemäß einer weiteren Ausführungsform weist das mindestens eine Anpassungsmodul ein oder mehrere in Reflexion oder in Transmission verwendete diffraktive Strukturmuster auf. Beispielsweise enthält das mindestens eine Anpassungsmodul ein oder mehrere CGHs mit diffraktiven Strukturmustern. Gemäß einer Ausführungsform ist mindestens ein CGH im Strahlengang der Wellenfrontmessvorrichtung vor oder nach dem zu vermessenden Modul oder jeweils in beiden Anpassungsmodulen vorgesehen. Insbesondere können auch zwei oder mehr nacheinander angeordnete diffraktive Strukturmuster, wie beispielsweise CGHs mit jeweils einer diffraktiven Struktur in Reflexion betrieben werden.

Bei einer Ausführungsform enthält das mindestens eine Anpassungsmodul mindestens zwei in einem Strahlengang der Messstrahlung einander überlagernd oder hintereinander angeordnete diffraktive Strukturmuster. Insbesondere sind die hintereinander angeordneten diffraktiven Strukturmuster jeweils auf einem eigenen Substrat vorgesehen, wie es z.B. in der US 2012/ 0127481 A1 beschrieben wird. Gemäß einer Ausführungsform werden zwei oder mehr im Strahlengang hintereinander angeordnete CGHs verwendet. Gemäß einer weiteren Ausführungsform sind die zwei sich überlagernden Strukturmuster auf einem einzigen Substrat in derselben Ebene angeordnet, wie es z.B. in der DE 10 2012 217 800 A1 offenbart wird. Beispielsweise kann mindestens ein komplex kodiertes CGH mit zwei oder mehr einander überlagernd angeordneten diffraktiven Strukturmustern in dem Anpassungsmodul vorgesehen sein.

Weiterhin wird gemäß dem ersten Aspekt der Erfindung die Aufgabe durch das nachfolgend beschriebene Verfahren zum Vermessen eines Wellenfrontfehlers eines abbildenden optischen Systems einer Projektionsbelichtungsanlage für die Mikrolithographie gelöst. Das optische System enthält mehrere optische Elemente zum Abbilden eines Musters aus einer Objektebene in eine Bildebene. Das Verfahren umfasst eine separate Vermessung jeweiliger Wellenfrontfehler unterschiedlicher Teilanordnungen der optischen Elemente.

Unter einer Teilanordnung der optischen Elemente ist eine Anordnung eines Teils der optischen Elemente zu verstehen und umfasst damit jeweils mindestens zwei optische Elemente. Die unterschiedlichen Teilanordnungen umfassen jeweils eine andere Kombination der optischen Elemente, wobei bei jeder Kombination mindestens ein optisches Element gegenüber dem abbildenden optischen System fehlt.

Durch die erfindungsgemäße separate Vermessung der unterschiedlichen Teilanordnungen, insbesondere einzelner optischer Module, lässt sich die Ursache für einen Wellenfrontfehler des abbildenden optischen Systems auf eines der Teilanordnungen eingrenzen. Als nächster Schritt kann dann z.B. eine Vermessung der einzelnen optischen Elemente dieser Teilanordnung erfolgen. Weiterhin kann ggf. durch eine geschickte Konfiguration der vermessenen Teilanordnungen bereits aus den Messergebnissen der Teilanordnungen ein einzelnes optisches Element als Fehlerquelle identifiziert werden. Eine Einzelvermessung sämtlicher optischer Elemente des abbildenden optischen Systems ist jedenfalls nicht erforderlich. Damit wird der für die Ursachenbestimmung eines Wellenfrontfehlers des abbildenden optischen Systems benötigte Zeitaufwand ohne Genauigkeitsverlust gering gehalten. Weiterhin kann durch die separate Vermessung der einzelnen Teilanordnungen auch auf Justagefehler der optischen Elemente eines als fehlerursächlich eingegrenzten optischen Moduls geschlossen werden, die mittels Einzelvermessung nicht und mittels Wellenfrontvermessung des abbildenden optischen Systems als Ganzes ggf. nur sehr schwer bestimmbar sind.

Gemäß einer möglichen Ausführungsform unterscheidet sich eine der Teilanordnungen der optischen Elemente von mindestens einem Abschnitt des abbildenden optischen Systems durch das Vorliegen einer mindestens ein optisches Element betreffenden Lücke. Eine Lücke in der Anordnung ist dadurch gekennzeichnet, dass im Strahlengang des abbildenden optischen Systems der Lücke mindestens ein optisches Element vorangestellt sowie mindestens ein optisches Element nachgeordnet ist.

Gemäß einer weiteren Ausführungsform wird das abbildende optische System mit mehreren, jeweils mindestens zwei der optischen Elemente umfassenden, optischen Modulen bereitgestellt und das separate Vermessen der jeweiligen Wellenfrontfehler unterschiedlicher Teilanordnungen erfolgt durch ein separates Vermessen jeweiliger Wellenfrontfehler der einzelnen optischen Module. Mit anderen Worten werden die unterschiedlichen Teilanordnungen durch die optischen Module gebildet. Mit anderen Worten ist das abbildende optische System in mehrere Module aufgeteilt. Jedes der Module umfasst mindestens zwei vorzugsweise nacheinander im Strahlengang des optischen Systems angeordnete optische Elemente. Insbesondere lässt sich jedes optische Modul als Ganzes aus dem optischen System entnehmen und wieder in dieses einfügen. Gemäß einer Ausführungsform werden Justagemittel zum Justieren eines oder mehrerer Module in dem optischen System bereitgestellt.

Gemäß einer Ausführungsform ist das abbildende optische System ein Projektionsobjektiv einer Projektionsbelichtungsanlage für die Mikrolithographie. Das abbildende optische System kann auch eine andere abbildende optische Baugruppe aus dem Belichtungsstrahlengang der Projektionsbelichtungsanlage, wie eine abbildende optische Baugruppe eines Beleuchtungssystems der Projektionsbelichtungsanlage, sein. Gemäß einer weiteren Ausführungsform kann das abbildende optische System mindestens ein Teil entweder eines Projektionsobjektivs oder eines Beleuchtungssystems einer Projektionsbelichtungsanlage, d.h. entweder ein Teil des Projektionsobjektivs bzw. des Beleuchtungssystems oder das ganze Projektionsobjektiv bzw. das ganze Beleuchtungssystem sein. Gemäß einer weiteren Ausführungsform ist mindestens eine der Teilanordnungen keine abbildende Optik, sondern eine nicht-stigmatische Opitk, wie vorstehend definiert, oder z.B. eine Optik mit defokussierender bzw. strahlaufweitender Wirkung. Gemäß einer weiteren Ausführungsform sind die Teilanordnungen in Gestalt der optischen Module des abbildenden optischen Systems im Betrieb der Projektionsbelichtungsanlage in einem gemeinsamen Gehäuse enthalten.

Gemäß einer Ausführungsform umfasst das erfindungsgemäße Verfahren weiterhin ein Zusammenfügen der Messergebnisse für die einzelnen Teilanordnungen zu einem Ergebnis für den Wellenfrontfehler des gesamten abbildenden optischen Systems. Eine Vermessung des Wellenfrontfehlers des gesamten abbildenden optischen Systems erfolgt damit durch eine separate Vermessung der Teilanordnungen und ein anschließendes Zusammenfügen der Messergebnisse zu einem Gesamtergebnis. Für eine Vermessung des ganzen abbildenden optischen Systems nach einer Nachbearbeitung oder Anpassung an bestimmte Anforderungen muss nur die jeweils bearbeitete Teilanordnung erneut vermessen werden. Durch einen modularen Aufbau des abbildenden optischen Systems wird eine Nachbearbeitung oder Anpassung wesentlich schneller und unkomplizierter durchführbar.

Gemäß einer Ausführungsform ist das abbildende optische System ein Projektionsobjektiv einer Projektionsbelichtungsanlage für die Mikrolithographie, insbesondere einer EUV-Projektionsbelichtungsanlage.

Gemäß einer weiteren Ausführungsform des Verfahrens nach der Erfindung umfasst die Vermessung eines der Teilanordnungen ein derartiges Anordnen der zu vermessenden Teilanordnung und mindestens eines Anpassungsmoduls im Strahlengang einer Messstrahlung einer Wellenfrontmessvorrichtung, sodass die Kombination aus der zu vermessenden Teilanordnung und dem mindestens einen Anpassungsmodul eine abbildende optische Anordnung bildet. Weiterhin umfasst die Vermessung eine Bestimmung des Wellenfrontfehlers der abbildenden optischen Anordnung mittels der Wellenfrontmessvorrichtung. Der Wellenfrontfehler des zu vermessenden optischen Moduls kann dann durch ein Herausrechnen eines vorbekannten Wellenfrontfehlers des Anpassungsmoduls aus dem bestimmten Wellenfrontfehler der abbildenden optischen Anordnung bestimmt werden.

Die durch Kombination aus der zu vermessenden Teilanordnung und dem Anpassungsmodul gebildete abbildende optische Anordnung kann in einer Ausführungsform derart konfiguriert sein, dass sie in ihrer optischen Wirkung dem zu vermessenden abbildenden optischen System entspricht. Alternativ kann die optische Anordnung auch andere Abbildungseigenschaften, insbesondere eine andere Brennweite oder einen anderen Abbildungsmaßstab aufweisen.

Das Anpassungsmodul weist mindestens ein optisches Element auf. Das oder die optischen Elemente des Anpassungsmoduls sind derart ausgebildet und angeordnet, dass diese zusammen mit der zu vermessenden Teilanordnung die vorgenannte abbildende optische Anordnung bilden. Durch die abbildende Eigenschaft der optischen Anordnung lassen sich insbesondere Wellenfrontmessvorrichtungen für abbildende optische Systeme zur Vermessung der Teilanordnung verwenden.

Gemäß einer Ausführungsform wird als Wellenfrontmessvorrichtung eine Vorrichtung zur phasenschiebenden Interferometrie, insbesondere eine Vorrichtung zur Scherinterferometrie oder zur Punktbeugungsinterferometrie verwendet. Dafür bildet die optische Anordnung aus dem mindestens einen Anpassungsmodul und der zu vermessendem Teilanordnung bei einer Ausführungsform eine in der Objektebene der optischen Anordnung positionierte Öffnung einer Lochblende (Pinhole) oder eine Kohärenzmaske der Wellenfrontmessvorrichtung auf ein in der Bildebene der optischen Anordnung angeordnetes Schergitter ab.

Gemäß einer Ausführungsform erfolgt ein Anordnen eines Anpassungsmoduls im Strahlengang der Wellenfrontmessvorrichtung vor der zu vermessenden Teilanordnung. Ein solches Anordnen eignet sich besonders zur Vermessung eines im Strahlengang des abbildenden optischen Systems als letztes vor der Bildebene oder einer anderen Feldebene vorgesehenen Moduls. Bei einer weiteren Ausführungsform wird das Anpassungsmodul im Strahlengang der Wellenfrontmessvorrichtung nach der zu vermessenden Teilanordnung angeordnet. Dieses Anordnen ist zum Vermessen einer im Strahlengang des abbildenden optischen Systems als erstes nach der Objektebene oder einer anderen Feldebene vorgesehenen Teilanordnung vorteilhaft.

Gemäß einer weiteren Ausführungsform des Verfahrens umfasst das Anordnen des mindestens einen Anpassungsmoduls ein Anordnen eines eingangsseitigen Anpassungsmoduls zum Manipulieren der Messstrahlung vor der zu vermessenden Teilanordnung, und ein Anordnen eines ausgangsseitigen Anpassungsmoduls zum Manipulieren der Messstrahlung nach der zu vermessenden Teilanordnung. Beide Anpassungsmodule weisen mindestens ein optisches Element auf. Das oder die optischen Elemente der Anpassungsmodule sind derart ausgebildet und angeordnet, dass die beiden Anpassungsmodule zusammen mit dem zu vermessenden Modul eine abbildende optische Anordnung bilden. Gemäß einer Ausführungsform des erfinderischen Verfahrens werden derart konfigurierte Anpassungsmodule in der Messstrahlung angeordnet, dass die optische Anordnung in ihrer optischen Wirkung dem zu vermessenden abbildenden optischen System entspricht. Alternativ kann die optische Anordnung auch andere Abbildungseigenschaften, insbesondere eine andere Brennweite oder einen anderen Abbildungsmaßstab aufweisen. Das Anordnen von zwei Anpassungsmodulen eignet sich besonders zur Vermessung eines optischen Moduls, welches im Strahlengang des abbildenden optischen Systems zwischen zwei anderen Modulen bzw. nicht unmittelbar vor oder nach einer Feldebene des optischen Systems vorgesehen ist.

Bei einer Ausführungsform des erfindungsgemäßen Verfahrens wird in dem mindestens einen Anpassungsmodul mindestens ein diffraktives Strukturmuster zur Manipulation der Wellenfront der Messstrahlung verwendet. Insbesondere wird das diffraktive Strukturmuster in Transmission betrieben. Als diffraktives Strukturmuster kann beispielweise ein diffraktives Strukturmuster eines computergenerierten Hologramms (CGH) verwendet werden. Ein computergeneriertes Hologramm wird durch Berechnen einer geeigneten Linienstruktur als diffraktive Struktur unter Verwendung eines Computers und geeigneter Verfahren, wie beispielsweise Strahlennachverfolgung, und anschließendes Schreiben der berechneten Linienstruktur auf oder in die Oberfläche eines Substrats erzeugt. Das diffraktive Strukturmuster kann im Strahlengang der Wellenfrontmessvorrichtung zum Beispiel vor oder nach der zu vermessenden Teilanordung angeordnet sein. Weiterhin kann auch in jedem der beiden oben beschriebenen Anpassungsmodule ein diffraktives Strukturmuster angeordnet sein.

Gemäß einer weiteren Ausführungsform des Verfahrens wird das diffraktive Strukturmuster zur Manipulation der Wellenfront der Messstrahlung in Reflexion betrieben. Beispielsweise wird als diffraktives Strukturmuster ein diffraktives Strukturmuster eines CGHs verwendet. Insbesondere können auch zwei oder mehr nacheinander angeordnete diffraktive Strukturmuster, wie beispielsweise CGHs mit jeweils einer diffraktiven Struktur in Reflexion betrieben werden. Das oder die CGHs sind im Strahlengang der Wellenfrontmessvorrichtung beispielsweise vor oder nach der zu vermessenden Teilanordnung angeordnet. Weiterhin werden in einer Ausführungsform in Reflexion betriebene CGHs in beiden Anpassungsmodulen verwendet. In Reflexion betriebene CGHs ermöglichen insbesondere eine Vermessung der Teilanordnung mit EUV-Strahlung.

Gemäß einer Ausführungsform des Verfahrens nach der Erfindung werden in dem mindestens einen Anpassungsmodul mindestens zwei im Strahlengang der Messstrahlung aufeinanderfolgend angeordnete diffraktive Strukturmuster zur Manipulation der Messstrahlung verwendet. Mit anderen Worten sind die diffraktiven Strukturmuster derart angeordnet, dass die Messstrahlung nacheinander mit den beiden diffraktiven Strukturmustern in Wechselwirkung tritt. Insbesondere sind das erste diffraktive Strukturmuster und das zweite diffraktive Strukturmuster jeweils auf einem eigenen Substrat angeordnet. Eine solche diffraktive Anordnung wird beispielsweise in der Patentanmeldung US 2012/0127481 A1 offenbart. Beispielsweise werden zwei im Strahlengang hintereinander angeordnete CGHs verwendet. Eine solche Anordnung von diffraktiven Strukturen, auch "Doppel-CGH" bezeichnet, ermöglicht eine gleichzeitige Änderung des Orts und der Richtung eines Messstrahls. Auf diese Weise ist es möglich, die Abbildungseigenschaften der optischen Anordnung mit der zu vermessenden Teilanordnung und dem mindestens einen Anpassungsmodul besonders gut an die Abbildungseigenschaften des zu vermessenden optischen Systems anzupassen.

Gemäß einer Ausführungsform nach der Erfindung werden in dem mindestens einen Anpassungsmodul mindestens zwei im Strahlengang einander überlagernd angeordnete diffraktive Strukturmuster zur Manipulation der Messstrahlung verwendet. Insbesondere sind die zwei diffraktiven Strukturmuster einander überlagernd auf einem einzigen Substrat in derselben Ebene angeordnet. Solche sich überlagernde diffraktive Strukturmuster zur Erzeugung separater Ausgangswellen mit unterschiedlicher Ausbreitungsrichtung werden beispielsweise in der DE 10 2012 217 800 A1 beschrieben. Gemäß einer Ausführungsform wird in einem Anpassungsmodul ein komplex kodiertes CGH mit zwei oder mehr einander überlagernd angeordneten diffraktiven Strukturmustern verwendet. An einem Ort der diffraktiven Strukturen erfolgt somit eine unterschiedliche Umlenkung verschiedener Messstrahlen. Durch diese Maßnahme lassen sich insbesondere mehr als ein Feldpunkt, z.B. ein Pinhole-Array, in der Objektebene der optischen Anordnung simultan auf ein Schergitter in der Bildebene der optischen Anordnung abbilden.

Weiterhin wird gemäß dem ersten Aspekt der Erfindung das nachfolgend beschriebene Verfahren zum Vermessen eines Wellenfrontfehlers eines abbildenden optischen Systems einer Projektionsbelichtungsanlage für die Mikrolithographie bereitgestellt. Das optische System enthält mehrere optische Elemente zum Abbilden eines Musters aus einer Objektebene in eine Bildebene. Das Verfahren umfasst ein Bereitstellen des abbildenden optischen Systems mit mehreren, jeweils mindestens zwei der optischen Elemente umfassenden, optischen Modulen. Weiterhin umfasst das Verfahren eine separate Vermessung jeweiliger Wellenfrontfehler der einzelnen optischen Module.

Mit anderen Worten sind in dem abbildenden optischen System mehrere Module vorgesehen. Jedes der Module umfasst mindestens zwei, vorzugsweise nacheinander im Strahlengang des optischen Systems angeordnete, optische Elemente. Insbesondere lässt sich jedes Modul als Ganzes aus dem optischen System entnehmen und wieder in dieses einfügen. Gemäß einer Ausführungsform werden Justagemittel zum Justieren eines oder mehrerer Module in dem optischen System bereitgestellt.

Gemäß einem zweiten Aspekt der Erfindung wird die Aufgabe durch die nachstehend beschriebene Messvorrichtung zur interferometrischen Formvermessung optischer Oberflächen einer Projektionsbelichtungsanlage für die Mikrolithographie gelöst. Die Messvorrichtung enthält ein einstückiges Wellenformelement, welches diffraktive Strukturen zum Erzeugen einer Messstrahlung mit einer an mindestens zwei nebeneinander angeordnete, nicht zusammenhängende optische Oberflächen angepassten Wellenfront aufweist. Dabei ist die Messvorrichtung dazu konfiguriert, eine relative Positionierung der optischen Oberflächen zueinander bezüglich mindestens eines Starrkörperfreiheitsgrades zu vermessen. Weiterhin umfasst die Messvorrichtung ein Interferometer zur interferometrischen Vermessung der Messstrahlung nach Wechselwirkung mit den optischen Oberflächen.

Durch die Möglichkeit der Vermessung der relativen Positionierung der optischen Oberflächen zueinander bezüglich mindestens eines Starrkörperfreiheitsgrades kann aus dem interferometrischen Messergebnis unter Berücksichtigung der bestimmten relativen Positionierung eine jeweilige Form der optischen Oberflächen bestimmt werden. Dies ermöglicht die gleichzeitige Formvermessung beider optischer Oberflächen. Damit verringert sich der zur Vermessung einiger oder aller optischer Elemente eines abbildenden optischen Systems der vorstehend mit Bezug auf den ersten Aspekt der Erfindung beschriebenen Art, wie etwa eines Projektionsobjektivs für die Mikrolithographie, benötigte Zeitaufwand. Die Zeit zur Bestimmung der Ursache eines Wellenfrontfehlers des abbildenden optischen Systems verringert sich damit.

Gemäß einer Ausführungsform umfasst die Messvorrichtung gemäß dem zweiten Aspekt der Erfindung eine Auswerteeinrichtung zum Bestimmen einer jeweiligen Form der optischen Oberflächen aus dem interferometrischen Messergebnis unter Berücksichtigung der bestimmten relativen Positionierung.

Ferner wird die Aufgabe gemäß einem zweiten Aspekt der Erfindung durch das nachstehende Verfahren zur interferometrischen Formvermessung optischer Oberflächen einer Projektionsbelichtungsanlage für die Mikrolithographie gelöst. Das Verfahren umfasst die folgenden Schritte: Anordnen von mindestens zwei nicht zusammenhängenden optischen Oberflächen in einem Strahlengang einer Messstrahlung, welche von einem diffraktive Strukturen aufweisenden, einstückigen Wellenformelement mit einer an die optischen Oberflächen angepassten Wellenfront erzeugt wird; Bestimmen einer relativen Positionierung der optischen Oberflächen zueinander bezüglich mindestens eines Starrkörperfreiheitsgrades; und ein gleichzeitiges interferometrisches Vermessen der jeweiligen Form der optischen Oberflächen mittels der Messstrahlung unter Berücksichtigung der bestimmten relativen Positionierung.

Mit anderen Worten erzeugt bei der erfindungsgemäßen Messvorrichtung und dem Verfahren das Wellenformelement mittels seiner diffraktiven Strukturen eine Messstrahlung, welche auf jede der optischen Oberflächen gerichtet ist. Zusätzlich ist die Wellenfront der eine Oberfläche erreichenden Messstrahlung jeweils an die Form dieser Oberfläche angepasst. Insbesondere können die diffraktiven Strukturen dazu eine, beispielsweise von einem Interferometer bereitgestellte Prüfstrahlung derart transformieren, dass für jede optische Oberfläche jeweils eine Messwelle mit entsprechend angepasster Wellenfront erzeugt wird. Die Anpassung der Wellenfront ist vorzugsweise so ausgebildet, dass die Wellenfront am Ort jeder optischen Oberfläche der jeweiligen Sollform der Oberfläche entspricht. Auf diese Weise wird für jede Oberfläche eine Nulloptik realisiert, bei welcher eine Oberfläche in Sollform die Messstrahlung in sich zurückreflektieren würde.

Als Wellenformelement wird beispielsweise ein CGH mit nebeneinander auf einem Substrat angeordneten diffraktive Strukturen für jede der optischen Oberflächen verwendet. Alternativ kann auch ein komplex kodiertes CGH mit sich einander in einer Ebene überlagernden diffraktiven Strukturen für zwei oder mehr Oberflächen vorgesehen sein.

Von den optischen Oberflächen wird die Messstrahlung zurückreflektiert, durchläuft wiederum das einstückige Wellenformelement und wird anschließend in dem Interferometer durch Überlagerung mit einer Referenzwelle vermessen. Dabei entsteht für jede Oberfläche bei einer Abweichung von der jeweiligen Sollform ein charakteristisches Interferogramm. Als Interferometer kann beispielsweise ein Fizeau-, ein Michelson- oder ein Twyman-Green-Interferometer verwendet werden. Wesentlich ist lediglich eine Erfassung eines Interferogramms bei einer Überlagerung der reflektierten Messstrahlung mit einer Referenzwelle. Die Erfassung eines Interferogramms kann beispielsweise durch eine CCD-Kamera erfolgen.

Zusätzlich erfolgt eine Bestimmung der relativen Positionierung der optischen Oberflächen zueinander. Dabei wird mindestens eine relative Orts- oder Kippkoordinate als relativer Starrkörperfreiheitsgrad bestimmt. Hierfür können beispielsweise interferometrische Verfahren verwendet werden. Eine Auswerteeinrichtung kann schließlich die Form jeder optischen Fläche und deren relative Positionierung zueinander mittels der erfassten Interferogramme und unter Berücksichtigung des mindestens einen vermessenen Starrkörperfreiheitsgrads bestimmen. Dabei können Werte weiterer Starrkörperfreiheitsgrade mit Hilfe der erfassten Werte und Interferogramme ermittelt werden. Alternativ kann auch eine Speicherung der erfassten Interferogramme und Werte von relativen Starrkörperfreiheitsgraden für eine spätere Auswertung oder ein Übermittlung an eine externe Auswerteeinheit vorgesehen sein.

Gemäß einer Ausführungsform sind die optischen Oberflächen Teil eines Projektionsobjektivs einer Projektionsbelichtungsanlage für die Mikrolithographie, insbesondere einer EUV-Projektionsbelichtungsanlage. Beispielsweise sind die optischen Oberflächen reflektierende Oberflächen von Spiegeln eines EUV-Projektionsobjektivs. Die Oberflächen können zum Beispiel eben, sphärisch oder asphärisch mit oder ohne Rotationssymmetrie ausgebildet sein.

Eine Ausführungsform der Messvorrichtung nach der Erfindung ist dazu konfiguriert, die relative Positionierung der optischen Oberflächen zueinander in einer Richtung quer zu den optischen Oberflächen zu vermessen. Insbesondere erfolgt die Vermessung der relativen Positionierung in Richtung einer mittleren Ausbreitungsrichtung der Messstrahlung. Gemäß einer Ausführungsvariante ist die Messvorrichtung dazu konfiguriert, die relative Positionierung der optischen Oberflächen zueinander zusätzlich in einer oder in beiden Erstreckungsrichtungen der optischen Oberflächen zu vermessen.

Gemäß einer weiteren Ausführungsform der Messvorrichtung nach der Erfindung weist das Wellenformelement diffraktive Hilfsmessstrukturen zur Erzeugung von Hilfswellen auf, welche jeweils auf eine der optischen Oberflächen fokussiert sind.

Die Hilfsmessstrukturen transformieren insbesondere einen Teil der Messstrahlung zu Hilfswellen. Dabei können für jede optische Oberfläche eine oder mehrere diffraktive Hilfsmessstrukturen vorgesehen sein. Gemäß einer Ausführungsform sind die Hilfsmessstrukturen als zusätzliche diffraktive Strukturen auf einem CGH als Wellenformelement ausgebildet.

Gemäß einer weiteren Ausführungsform weist die Messvorrichtung mehrere Wellenformelemente oder ein Wellenformelement mit mehreren diffraktiven Strukturen zum Vermessen von jeweils einem Teilbereich mindestens einer der optischen Oberflächen auf. Insbesondere ist dabei die Auswerteeinrichtung zum Zusammensetzen von Teilmessungen zu einer Gesamtmessung der optischen Oberflächen ausgebildet. Insbesondere kann die Messvorrichtung zum Verwenden verschiedener, beispielsweise als CGH ausgebildeter Wellenformelemente zum aufeinanderfolgenden Vermessen von unterschiedlichen Teilbereichen einer oder mehrerer optischer Oberflächen ausgebildet sein. Alternativ oder zusätzlich kann auch eine Verschlusseinrichtung, z.B. mit einem oder mehreren Shuttern, vorgesehen sein, welche eine Messstrahlung nur für auswählbare Teilbereiche passieren lässt. Ein Zusammensetzen der Teilmessung zu einer Gesamtmessung der Oberflächen kann beispielsweise durch ein sogenanntes Stitching erfolgen, welches z.B. in der WO 2005/114101 A1 beschrieben wird. Mit dieser Maßnahme lassen sich auch Oberflächen vermessen, bei denen sich die reflektierte Messstrahlung von zwei oder mehr Oberflächen zumindest teilweise kreuzt. In einem solchen Fall, welcher dem Fachmann auch als "Kaustik" bekannt ist, kann der entsprechende Abschnitt des Interferenzmusters nicht mehr eindeutig einer optischen Fläche zugeordnet werden. Durch eine nacheinander erfolgende Vermessung von Teilbereichen kann ein solches Ineinanderlaufen der reflektierten Messstrahlung vermieden werden. Ferner lassen sich mit dieser Ausführungsform auch sehr große optische Oberflächen vollständig vermessen.

Bei einer Ausführungsform des erfindungsgemäßen Verfahrens zur interferometrischen Formvermessung optischer Oberflächen erfolgt eine Vermessung der relativen Positionierung der optischen Oberflächen zueinander mittels Hilfswellen, welche mit Hilfsmessstrukturen des Wellenformelements aus der Messstrahlung erzeugt werden. Die Hilfsmessstrukturen transformieren insbesondere einen Teil der Messstrahlung zu Hilfswellen. Gemäß einer Ausführungsvariante werden für jede optische Oberfläche eine oder mehrere Hilfswellen erzeugt. Die Hilfsmessstrukturen können als zusätzliche diffraktive Strukturmuster bei einem CGH als Wellenfrontelement bereitgestellt werden.

Gemäß einer Ausführungsform des Verfahrens zur Formvermessung werden nacheinander mit verschiedenen Wellenformelementen oder verschiedenen diffraktiven Strukturen eines Wellenformelements jeweils Teilbereiche mindestens einer der optischen Oberflächen vermessen. Anschließend erfolgt ein Zusammensetzen von Teilmessungen zu einer Gesamtvermessung der optischen Oberflächen. Entsprechend zur korrespondierenden Ausführungsform der Messvorrichtung können beispielsweise nacheinander unterschiedliche CGHs für verschiedene Teilbereiche, eine Verschlussvorrichtung zum Blockieren der Messstrahlung für bestimmte Teilbereiche oder beides verwendet werden. Das Zusammensetzen von Teilmessungen erfolgt vorzugsweise durch das oben erwähnte Stitching-Verfahren.

Ferner sind gemäß einer Ausführung des Verfahrens zur interferometrischen Formvermessung optischer Oberflächen die nicht zusammenhängenden optischen Oberflächen auf einem gemeinsamen Substrat angeordnet. Insbesondere sind die optischen Oberflächen nebeneinander auf einer Seite des Substrats positioniert. Dabei können die optischen Oberflächen beispielsweise zur Reflexion einer Beleuchtungsstrahlung der Projektionsbelichtungsanlage ausgebildet sein und somit einen Doppelspiegel oder Mehrfachspiegel darstellen. Mit der Verwendung eines Substrats für mehrere Oberflächen wird eine besonders kompakte Bauweise realisiert.

Gemäß einer alternativen Ausführungsform sind die nicht zusammenhängenden optischen Oberflächen jeweils auf separaten Substraten angeordnet. Somit lassen sich zum Beispiel auch zwei oder mehr nebeneinander angeordnete Spiegel gleichzeitig vermessen, wie etwa zwei nebeneinander angeordnete Spiegel mit flachem Einstrahlwinkel für ein Projektionsobjektiv der EUV-Mikrolithographie. Dabei wird neben der jeweiligen Form auch die relative Lage zueinander bestimmt.

Die bezüglich der vorstehend aufgeführten Ausführungsformen, Ausführungsbeispiele bzw. Ausführungsvarianten, etc. der erfindungsgemäßen Messanordnung gemäß dem ersten Aspekt und der Messvorrichtung gemäß dem zweiten Aspekt angegebenen Merkmale können entsprechend auf das jeweilige erfindungsgemäße Verfahren gemäß dem ersten Aspekt oder dem zweiten Aspekt übertragen werden und umgekehrt. Weiterhin können die bezüglich der vorstehend aufgeführten Ausführungsformen, Ausführungsbeispiele bzw. Ausführungsvarianten, etc. der erfindungsgemäßen Verfahrens und der erfindungsgemäßen Messanordnung gemäß dem ersten Aspekt der Erfindung auf die erfindungsgemäße Messvorrichtung und das erfindungsgemäße Verfahren gemäß dem zweiten Aspekt der Erfindung übertragen werden und umgekehrt. Diese und andere Merkmale der erfindungsgemäßen Ausführungsformen werden in der Figurenbeschreibung und den Ansprüchen erläutert. Die einzelnen Merkmale können entweder separat oder in Kombination als Ausführungsformen der Erfindung verwirklicht werden. Weiterhin können sie vorteilhafte Ausführungsformen beschreiben, die selbstständig schutzfähig sind und deren Schutz ggf. erst während oder nach Anhängigkeit der Anmeldung beansprucht wird.

### Kurzbeschreibung der Zeichnungen

Die vorstehenden, sowie weitere vorteilhafte Merkmale der Erfindung werden in der nachfolgenden detaillierten Beschreibung beispielhafter erfindungsgemäßer Ausführungsformen unter Bezugnahme auf die beigefügten schematischen Zeichnungen veranschaulicht. Es zeigt:
Fig. 1 ein Ausführungsbeispiel eines Projektionsobjektivs für die Mikrolithographie mit in optischen Modulen angeordneten optischen Elementen in einer schematischen Veranschaulichung,
Fig. 2 eine Wellenfrontmessvorrichtung für ein abbildendes optisches System in einer schematischen Veranschaulichung,
Fig. 3 ein Ausführungsbeispiel einer Messanordnung mit einem im Strahlengang nach einem optischen Modul angeordneten Anpassungsmodul in einer schematischen Veranschaulichung,
Fig. 4 ein weiteres Ausführungsbeispiel einer Messanordnung mit einem im Strahlengang nach einem optischen Modul angeordneten Anpassungsmodul in einer schematischen Veranschaulichung,
Fig. 5 ein Ausführungsbeispiel einer Messanordnung mit einem im Strahlengang vor einem optischen Modul angeordneten Anpassungsmodul in einer schematischen Veranschaulichung,
Fig. 6 ein Ausführungsbeispiel einer Messanordnung mit im Strahlengang vor und nach einem optischen Modul angeordneten Anpassungsmodulen in einer schematischen Veranschaulichung,
Fig. 7 ein Ausführungsbeispiel einer Messanordnung mit zwei im Strahlengang nacheinander angeordneten diffraktiven Strukturmustern in einer schematischen Veranschaulichung,
Fig. 8 ein Ausführungsbeispiel einer Messanordnung mit zwei im Strahlengang einander überlagernd angeordneten diffraktiven Strukturmustern in einer schematischen Veranschaulichung,
Fig. 9 eine weitere Ausführungsform eines Projektionsobjektivs für die Mikrolithographie mit in optischen Modulen angeordneten optischen Elementen in einer schematischen Veranschaulichung,
Fig. 10 ein weiteres Ausführungsbeispiel einer Messanordnung mit einem im Strahlengang zwischen zwei optischen Modulen angeordneten Anpassungsmodul in einer schematischen Veranschaulichung,
Fig. 11 eine Veranschaulichung einer Kalibrierung zweier Anpassungsmodule mittels eines Kalibriermoduls,
Fig. 12 ein weiteres Ausführungsbeispiel einer Messanordnung mit abbildenden optischen System sowie einem Anpassungsmodul zur Verkürzung einer ausgangsseitigen Schnittweite des abbildenden optischen Systems,
Fig. 13 ein weiteres Ausführungsbeispiel einer Messanordnung mit abbildenden optischen System sowie einem Anpassungsmodul zur Verkürzung einer eingangsseitigen Schnittweite des abbildenden optischen Systems,
Fig. 14 ein Ausführungsbeispiel einer Messvorrichtung zur interferometrischen Formvermessung von optischen Oberflächen in einer schematischen Veranschaulichung,
Fig. 15 das Ausführungsbeispiel nach Fig. 14 mit Hilfswellen zur Bestimmung einer relativen Position der optischen Oberflächen zueinander in einer schematischen Veranschaulichung,
Fig. 16 ein weiteres Ausführungsbeispiel einer Messvorrichtung zur interferometrischen Formvermessung von verschiedenen Teilbereichen optischer Oberflächen in einer schematischen Veranschaulichung, sowie
Fig. 17 das Ausführungsbeispiel nach Fig. 14 bei einer gleichzeitigen Vermessung von optischen Oberflächen zweier optischer Elemente.

### Detaillierte Beschreibung erfindungsgemäßer Ausführungsbeispiele

In den nachstehend beschriebenen Ausführungsbeispielen bzw. Ausführungsformen oder Ausführungsvarianten sind funktionell oder strukturell einander ähnliche Elemente soweit wie möglich mit den gleichen oder ähnlichen Bezugszeichen versehen. Daher sollte zum Verständnis der Merkmale der einzelnen Elemente eines bestimmten Ausführungsbeispiels auf die Beschreibung anderer Ausführungsbeispiele oder die allgemeine Beschreibung der Erfindung Bezug genommen werden. Zur Erleichterung der Beschreibung ist in einigen Zeichnungen ein kartesisches xyz-Koordinatensystem angegeben, aus dem sich die jeweilige Lagebeziehung der in den Figuren dargestellten Komponenten ergibt.

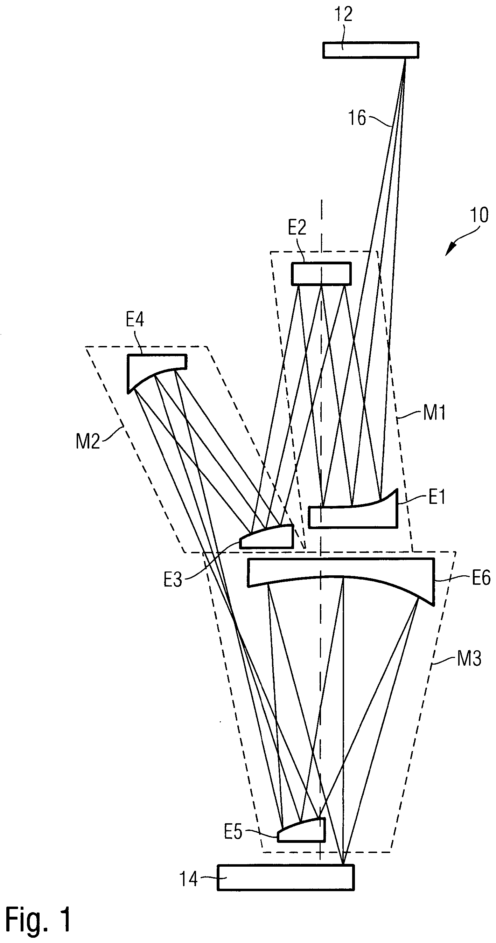

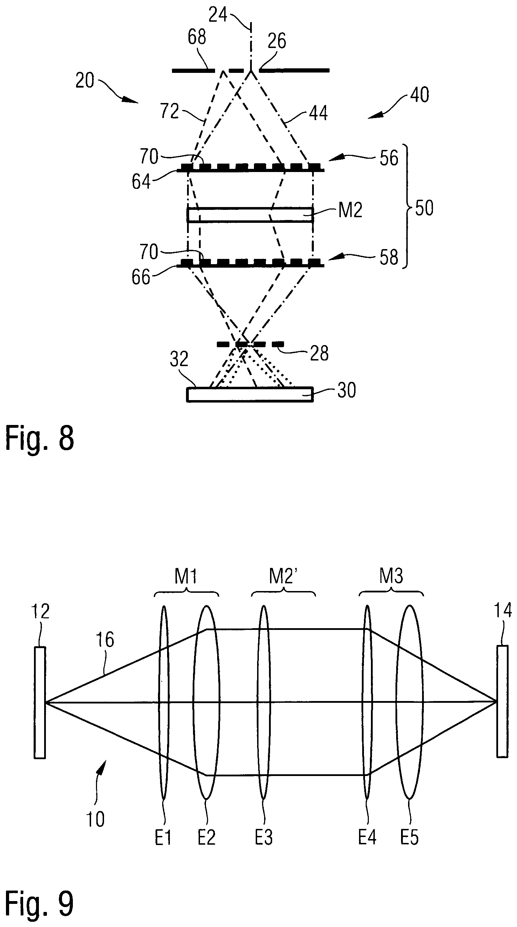

Die Figuren 1 bis 13 veranschaulichen einen ersten Aspekt der Erfindung. Fig. 1 zeigt eine Ausführungsform eines Projektionsobjektivs 10 einer Projektionsbelichtungsanlage für die Mikrolithographie in einer schematischen Darstellung. Das Projektionsobjektiv 10 bildet ein Muster einer Maske bzw. eines Retikels 12 auf eine strahlungsempfindliche Beschichtung eines Wafers 14 ab. Dazu sind das Muster des Retikels 12 in einer Objektebene und die strahlungsempfindliche Beschichtung des Wafers 14 in einer Bildebene des Projektionsobjektivs 10 angeordnet. Das Projektionsobjektiv 10 ist in diesem Ausführungsbeispiel für die Mikrolithographie mit EUV-Strahlung (extrem ultraviolette Strahlung) mit einer Wellenlänge von kleiner als 100 nm, insbesondere einer Wellenlänge von ungefähr 13,5 nm oder ungefähr 6,8 nm ausgebildet und enthält daher lediglich in Reflexion betriebene optische Elemente. Auch am Retikel 12 wird die von einem nicht dargestellten Beleuchtungssystem bereitgestellte EUV-Strahlung reflektiert. In alternativen Ausführungen können, insbesondere bei einer Belichtungsstrahlung in einem längerwelligen Spektralbereich, auch in Transmission verwendete optische Elemente, wie Linsen oder Prismen, oder auch ein Transmissions-Retikel zum Einsatz kommen. So kann beispielsweise auch die in Fig. 9 veranschaulichte Ausführungsform eines Projektionsobjektivs 10 mit optischen Elementen in Gestalt von Linsenelementen Verwendung finden.

Das Projektionsobjektiv 10 gemäß Fig. 1 umfasst sechs optische Elemente in Gestalt der Spiegel E1, E2, E3, E4, E5 und E6, welche ausgehend vom Retikel 12 nacheinander in einem Strahlengang 16 des Projektionsobjektivs 10 angeordnet sind. In Fig. 1 ist exemplarisch der Strahlengang 16 für einen Feldpunkt des Retikels 12 dargestellt. Der Spiegel E1 weist eine konkave Spiegelfläche auf und ist zusammen mit dem im Wesentlichen planen Spiegel E2 in einem ersten optischen Modul M1 angeordnet. Weiterhin ist der Spiegel E3 mit einer konvexen Spiegelfläche zusammen mit dem konkaven Spiegel E4 in einem zweiten optischen Modul M2 und der konvexe Spiegel E5 zusammen mit dem konkaven Spiegel E6 in einem dritten optischen Modul M3 angeordnet. Die Module M1, M2 und M3 enthalten somit jeweils im Strahlengang 16 aufeinanderfolgende optische Elemente. Jedes der Module M1, M2 und M3 stellt eine optische Einheit in Gestalt einer Teilanordnung der optischen Elemente in Gestalt der Spiegel E1 bis E6 des Projektionsobjektivs 10 dar. Mit anderen Worten umfasst jedes der Module M1 bis M3 einen Teil der Spiegel E1 bis E6, und zwar im vorliegenden Fall jeweils zwei dieser Spiegel.

Jedes Modul M1, M2, M3 lässt sich einzeln aus dem Projektionsobjektiv 10 entnehmen und wieder einsetzen. Mit entsprechenden Stellvorrichtungen ist neben einer Justage der einzelnen Spiegel E1, E2, E3, E4, E5, E6 auch eine Justage der einzelnen Module M1, M2, M3, jeweils als Ganzes, möglich. Auf diese Weise lassen sich einerseits optische Eigenschaften des Projektionsobjektivs 10 durch einen Austausch eines oder mehrerer Module M1, M2, M3 schnell an geänderte Anforderung anpassen. Andererseits ist für eine Nachbearbeitung eines der optischen Elemente des Projektionsobjektivs 10 zur Korrektur von Abbildungsfehlern lediglich eine Entnahme und ein eventuelles Zerlegen des entsprechenden Moduls M1, M2 oder M3 notwendig.

Die beschriebenen Module M1, M2, M3 stellen nur Beispiele für mögliche Module dar. In anderen Ausführungsbeispielen des Projektionsobjektivs 10 können Module mehr als zwei optische Elemente, wie beispielsweise drei oder vier optische Elemente, oder auch nur ein optisches Element enthalten. Je nach Aufbau kann das Projektionsobjektiv 10 weiterhin auch weniger oder mehr als drei Module und insbesondere auch von keinem Modul umfasste optische Elemente enthalten. Ferner ist ein modularer Aufbau von anderen Komponenten einer Projektionsbelichtungsanlage für die Mikrolithographie ebenfalls möglich, wie beispielsweise ein modular aufgebautes Beleuchtungssystem zum Beleuchten der Maske.

Bei der Herstellung von optischen Modulen oder der Nachbearbeitung einzelner Module bzw. in einem Modul enthaltener optischer Elemente ist eine sehr präzise Vermessung der optischen Eigenschaften des jeweiligen Moduls notwendig. Insbesondere müssen Abweichungen von einer gewünschten Wellenfront-änderung durch das Modul hochgenau bestimmt werden. Eine solche Vermessung der Wellenfrontfehler des Moduls lässt sich mit den bekannten Vorrichtungen zur Vermessung von Projektionsobjektiven in der Regel nicht ohne weiteres durchführen, da die einzelnen Module im Allgemeinen kein abbildendes optisches System darstellen.

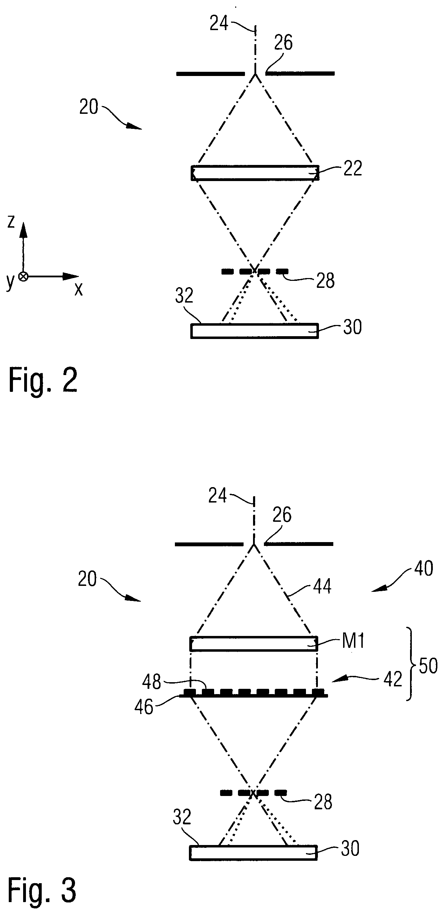

In Fig. 2 wird schematisch eine bekannte Wellenfrontmessvorrichtung 20 zur Vermessung einer abbildenden Optik 22 veranschaulicht. Die Wellenfrontmessvorrichtung 20 ist als ein auf phasenschiebener Interferometrietechnik beruhendes Scher-Interferometer ausgebildet und eignet sich beispielsweise zur sehr präzisen Bestimmung von Abbildungsfehlern eines Projektionsobjektivs oder einer anderen abbildenden Optik 22 der Mikrolithographie. Die Wellenfrontmessvorrichtung 20 enthält eine nicht dargestellte Strahlungsquelle, welche eine elektromagnetische Messstrahlung 24 bereitstellt. Die Wellenlänge der Messstrahlung 24 entspricht vorzugsweise der Wellenlänge der beim Betrieb des abbildenden optischen Systems 22 verwendeten Strahlung. Insbesondere dient EUV-Strahlung als Messstrahlung 24. Es kann aber auch eine Messstrahlung mit einer anderen Wellenlänge im sichtbaren oder nicht sichtbaren Spektralbereich bereitgestellt werden. Weiterhin enthält die Wellenfrontmessvorrichtung 20 eine in der Objektebene der abbildenden Optik 22 angeordnete Öffnung einer Lochblende 26 und ein in der Bildebene des abbildenden Systems 22 angeordnetes Schergitter 28. Anstelle der Lochblende 26 kann auch ein Pinhole-Raster oder eine Kohärenzmaske eingesetzt werden. Die Messstrahlung 24 durchtritt die Öffnung der Lochblende 26 und breitet sich danach mit einer sphärischen Wellenfront aus. Von der abbildenden Optik 22 wird die Messstrahlung 24 auf das Schergitter 28 abgebildet. Das Schergitter 28 stellt ein phasenschiebendes Beugungsgitter dar. Hinter dem Schergitter 28 ist ein Detektor 30 der Wellenfrontmessvorrichtung 20 angeordnet. Durch ein laterales Bewegen des Schergitters 28 in x- oder y-Richtung werden am Detektor 30 Interferenzmuster erfasst, aus denen sich die Ortsableitung der Wellenfront in der betreffenden Bewegungsrichtung und daraus schließlich Bildfehlerinformationen der abbildenden Optik 22 hochgenau ermitteln lassen. Eine solche Wellenfrontmessvorrichtung wird beispielsweise in DE 103 16 123 A1 beschrieben.

Eine Voraussetzung für eine Vermessung einer Optik mit der Wellenfrontmessvorrichtung 20 ist, dass die zu vermessende Optik die Öffnung der Lochblende 26 auf das Schergitter 28 abbildet. Wie bereits vorstehend erwähnt, ist dies jedoch bei Modulen eines abbildenden optischen Systems, wie beispielweise den Modulen M1 bis M3 des Projektionsobjektivs 10 gemäß Fig. 1, in der Regel nicht der Fall. Im Folgenden werden verschiedene Ausführungsbeispiele einer Messanordnung 40 zur Vermessung einer optischen Einheit, welche nicht geeignet ist, die Öffnung der Lochblende 26 auf das Schergitter 28 abzubilden, jeweils zusammen mit entsprechenden Verfahren beschrieben. Insbesondere ist die Messanordnung 40 zur Vermessung einer derartigen optischen Einheit konfiguriert, welche überhaupt keine abbildende Eigenschaft aufweist, sondern beispielsweise eine Optik mit defokussierender bzw. strahlaufweitender Wirkung ist. Die erfindungsgemäße Messanordnung 40 eignet sich daher zur jeweiligen Vermessung der einzelnen Module M1, M2 und M3 des Projektionsobjektivs 10 gemäß Fig. 1.

Fig. 3 veranschaulicht schematisch ein erstes Ausführungsbeispiel einer Messanordnung 40 zum Vermessen von Modul M1 des Projektionsobjektivs 10 gemäß Fig. 1. Die Messanordnung 40 umfasst die Wellenfrontmessvorrichtung 20 nach Fig. 2. Alternativ kann auch jede andere auf phasenschiebender Interferometrie, z.B. Scher- oder Punktbeugungsinterferometrie, oder einer anderen Technik beruhende Wellenfrontmessvorrichtung für abbildende optische Systeme verwendet werden. Weiterhin umfasst die Messanordnung 40 ein Anpassungsmodul 42, welches zusammen mit einem zu vermessenden Modul M1 im Strahlengang 44 der Messstrahlung 24 angeordnet wird. In diesem Ausführungsbeispiel ist das Anpassungsmodul 42 im Strahlengang 44 nach dem Modul M1 angeordnet und enthält ein in Transmission betriebenes CGH 46 mit einem diffraktiven Strukturmuster 48. Das diffraktive Strukturmuster 48 des CGHs 46 und damit auch das Anpassungsmodul 42 sind derart ausgebildet und angeordnet, das die Öffnung der Lochblende 26 durch die Kombination der optischen Wirkung des zu vermessenden Moduls M1 und des Anpassungsmoduls 42 auf das Schergitter 28 abgebildet wird. Alternativ oder zusätzlich zum CGH 46 kann das Anpassungsmodul 42 in anderen Ausführungsbeispielen auch refraktive oder reflektive optische Elemente, wie etwa Linsen oder Spiegel, enthalten.

Mit anderen Worten ergänzt das Anpassungsmodul 42 das zu vermessende Modul M1 zu einer abbildenden optischen Anordnung 50. Mit dem Modul M1 des Projektionsobjektivs 10 nach Fig. 1 als Beispiel eines zu vermessenden Moduls stellt das Anpassungsmodul 42 in seiner optischen Wirkung einen Ersatz bzw. eine Imitation der anderen Module M2 und M3 des Projektionsobjektivs 10 dar. Mit der Anordnung des Anpassungsmoduls 42 im Strahlengang 44 hinter dem zu vermessenden Modul M1 eignet sich dieses Ausführungsbeispiel somit besonders zur Vermessung von Modulen, welche im Strahlengang eines abbildenden Systems unmittelbar nach der Objektebene oder einer anderen Feldebene angeordnet sind. Bei einer Vermessung der optischen Anordnung 50 durch die Wellenfrontmessvorrichtung 20 wird mit Hilfe einer nicht dargestellten Auswertungseinrichtung ein Wellenfrontfehler der optischen Anordnung 50 bestimmt. Hieraus lässt sich unter Berücksichtigung der bekannten optischen Eigenschaften des Anpassungsmoduls 42 bzw. des CGHs 46 wiederum ein Wellenfrontfehler des Moduls M1 sehr genau bestimmen.

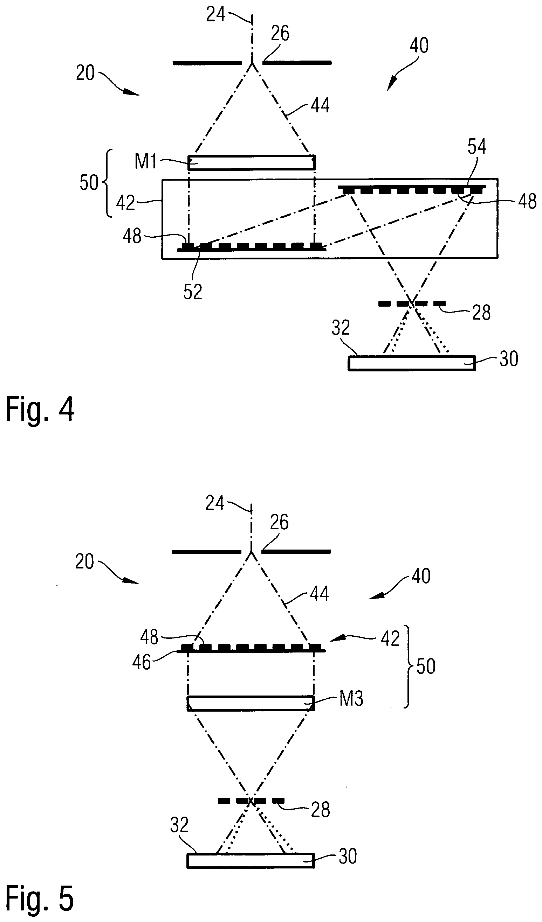

In Fig. 4 wird ein weiteres Ausführungsbeispiel einer Messanordnung 40 mit einem im Strahlengang 44 nach einem zu vermessenden Modul M1 angeordneten Anpassungsmodul 42 dargestellt. Die Messanordnung 40 entspricht im Wesentlichen der Messanordnung nach Fig. 3. Anstelle eines in Transmission betriebenen CGHs sind aber in dem Anpassungsmodul 42 zwei in Reflexion betriebene CGHs 52, 54 mit jeweils einem diffraktiven Strukturmuster 48 enthalten. Die beiden CGHs 52, 54 sind im Strahlengang 44 nacheinander angeordnet. Alternativ kann das Anpassungsmodul 42 nur ein oder mehr als zwei in Reflexion verwendete CGHs enthalten. Die diffraktiven Strukturmuster 48 der CGHs 52, 54 sind derart konfiguriert, dass sie zusammen mit dem Modul M1 die Öffnung der Lochblende 26 auf das Schergitter 28 abbilden. Ferner können zusätzlich auch weitere diffraktive, reflektive oder refraktive optische Element, wie beispielweise in Transmission betriebene CGHs, Spiegel oder Linsen in dem Anpassungsmodul 42 vorgesehen sein. Mit einer Verwendung von CGHs in Reflexion lässt sich das Modul M1 auch mit einer EUV-Messstrahlung 24 vermessen.

In Fig. 5 wird ein weiteres Ausführungsbeispiel einer Messanordnung 40 dargestellt. Die Messanordnung 40 unterscheidet sich von den vorherigen Messanordnungen durch eine andere Anordnung des Anpassungsmoduls 42 zur Vermessung eines Moduls M3. Das Modul M3 ist ein im Strahlengang eines abbildenden optischen Systems als letztes vor einer Bildebene oder einer anderen Feldebene angeordnetes Modul, beispielsweise das Modul M3 des Projektionsobjektivs 10 gemäß Fig. 1. Das Anpassungsmodul 42 ist im Strahlengang 44 der Wellenfrontmessvorrichtung 20 vor dem Modul M3 angeordnet. Es enthält ein in Transmission betriebenes CGH 46 mit einer diffraktiven Struktur 48. Die diffraktive Struktur 48 des CGHs 46 und damit auch das Anpassungsmodul 42 sind so konfiguriert und angeordnet, dass es zusammen mit dem Modul M3 eine abbildende optische Anordnung 50 darstellt. Die optische Anordnung 50 bildet insbesondere die Öffnung der Lochblende 26 auf das Schergitter 28 ab. Das Anpassungsmodul 42 ersetzt somit z.B. bei einer Vermessung des Moduls M3 des Projektionsobjektivs 10 durch seine optische Wirkung die Module M1 und M2. In anderen Ausführungen enthält das Anpassungsmodul 42 alternativ oder zusätzlich ein oder mehrere refraktive, reflektive oder in Reflexion betriebene diffraktive optische Elemente.

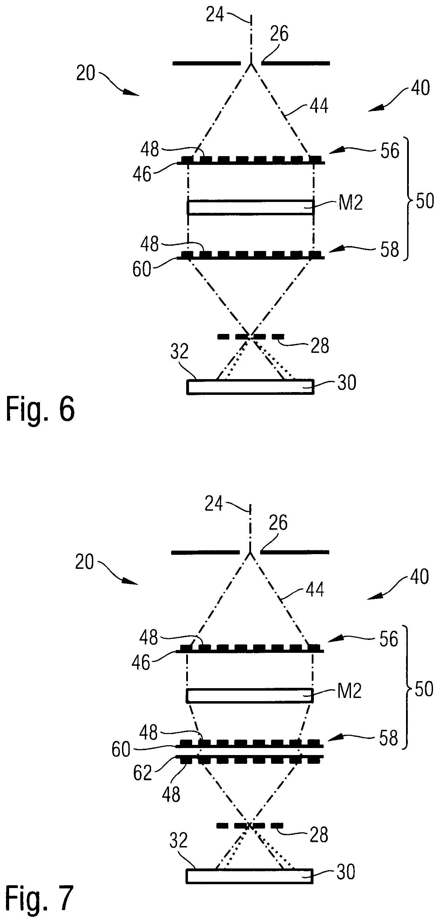

Fig. 6 zeigt schematisch ein Ausführungsbeispiel einer Messanordnung 40 mit einem im Strahlengang 44 vor einem zu vermessenden Modul M2, wie etwa dem optischen Modul M2 des Projektionsobjektivs 10 gemäß Fig. 1, angeordneten ersten Anpassungsmodul 56 und einem im Strahlengang 44 nach dem Modul M2 angeordneten zweiten Anpassungsmodul 58. Die Anpassungsmodule 56, 58 wiesen jeweils ein in Transmission betriebenes CGH 46, 60 mit einem diffraktiven Strukturmuster 48 auf. Die diffraktiven Strukturen 48 der beiden CGHs 46, 60 und somit auch die beiden Anpassungsmodule 56, 58 sind derart konfiguriert, dass sie zusammen mit dem Modul M2 eine abbildende Anordnung 50 für die Öffnung der Lochblende 26 darstellen. Bei einer Vermessung des Moduls M2 des Projektionsobjektivs 10 gemäß Fig. 1 ersetzt somit das Anpassungsmodul 56 in seiner optischen Wirkung das Modul M1 und das Anpassungsmodul 58 in seiner optischen Wirkung das Modul M3. Die Messanordnung 40 eignet sich daher besonders für Module eines abbildenden optischen Systems, welche weder direkt vor oder direkt nach einer Feldebene des optischen Systems angeordnet sind. Alternativ oder zusätzlich können in einem oder in beiden Anpassungsmodulen 56, 58 auch refraktive, reflektive oder in Reflexion betriebene diffraktive optische Elemente vorgesehen sein.

Fig. 7 zeigt ein weiteres Ausführungsbeispiel einer Messanordnung 40. Die Messanordnung 40 entspricht grundsätzlich der Messanordnung nach Fig. 6, sieht aber in dem Anpassungsmodul 58 zwei im Strahlengang 44 der Wellenfrontmessvorrichtung 20 hintereinander angeordnete CGHs 60, 62 mit jeweils einer diffraktiven Struktur 48 vor. Eine solche auch "Doppel-CGH" bekannte Anordnung wird beispielsweise in der Patentanmeldung US 2012/ 0127481 A1 beschrieben. In einer alternativen Ausführung kann eine der diffraktiven Strukturen auf einer Seite und die andere der diffraktive Strukturen auf einer anderen Seite eines Substrats angeordnet sein.

Ein Doppel-CGH ermöglicht eine gleichzeitige Änderung des Orts und der Richtung eines Messstrahls. Auf diese Weise lassen sich bei manchen zu vermessenden Modulen M2 eine abbildende Eigenschaft der optischen Anordnung 50 mit dem Anpassungsmodul und dem zu vermessenden Modul M2 besser erzielen. Beispielsweise kann bei einer Vermessung des Moduls M2 des Projektionsobjektivs 10 durch das Anpassungsmodul 58 mit den CGHs 60, 62 eine exakter an das zu ersetzende optische Modul M3 angepasste optische Wirkung erreicht werden.

In weiteren Ausführungen ist ein Doppel-CGH in dem im Strahlengang 44 vor dem Modul M2 angeordneten Anpassungsmodul 56 oder in beiden Anpassungsmodulen 56, 58 vorgesehen. Weiterhin können auch zwei in Reflexion betriebene CGHs als Doppel-CGH verwendet werden. Zusätzlich zum Doppel-CGH können weitere refraktive, reflektive oder diffraktive optische Elemente in einem oder in beiden der Anpassungsmodule 56, 58 angeordnet sein.

In Fig. 8 wird weiterhin ein Ausführungsbeispiel einer Messanordnung 40 gemäß Fig. 6 mit jeweils einem komplex kodierten CGH 64 bzw. 66 in den Anpassungsmodulen 56 und 58 und einer zweiten Lochblende 68 dargestellt. Jedes der komplex kodierten CGHs 64, 66 enthält zwei im Strahlengang 44 einander überlagernd angeordnete diffraktive Strukturmuster 70. Die diffraktiven Strukturmuster 70 sind insbesondere einander überlagernd in einer Ebene der CGHs 64, 66 angeordnet. Solche komplex kodierten CGHs werden z.B. in der DE 10 2012 217 800 A1 beschrieben. Die Messstrahlung 44 von der Öffnung der Lochblende 26 wird durch eine der diffraktive Strukturen der CGHs 64, 66 transformiert, während eine Messstrahlung 72 von der Öffnung der zweiten Lochblende 68 durch die andere diffraktive Struktur der CGHs 64 und 66 transformiert wird. Auf diese Weise stellen die Anpassungsmodule 56 und 58 zusammen mit dem Modul M2 eine optische Anordnung 50 dar, die gleichzeitig die Öffnung der erste Lochblende 26 und die Öffnung der zweite Lochblende 68 auf das Schergitter 28 abbilden. Es lassen sich damit zwei Feldpunkte der Objektebene der optischen Anordnung 50 simultan vermessen.

In anderen Ausführungen kann entsprechend zur Messvorrichtung nach Fig. 5 lediglich ein Anpassungsmodul 42 mit einem komplex kodierten CGH vor einem zu vermessenden Modul M3, oder analog zur Messvorrichtung nach Fig. 3 ein Anpassungsmodul mit einem komplex kodierten CGH nach einem zu vermessenden Modul M1 vorgesehen sein. Auch können zusätzlich zu den komplex kodierten CGHs 64, 66 weitere refraktive, reflektive oder diffraktive optische Elemente in einem oder in beiden der Anpassungsmodule 56, 58 oder in einem Anpassungsmodul 42 vor oder hinter dem zu vermessenden optischen Modul angeordnet sein.

Fig. 9 veranschaulicht eine weitere Ausführungsform eines Projektionsobjektivs 10 einer Projektionsbelichtungsanlage für die Mikrolithographie. Diese unterscheidet sich von der Ausführungsform gemäß Fig. 1 darin, dass bei dieser das Projektionsobjektiv 10 auf den Betrieb mit UV-Strahlung anstatt EUV-Strahlung ausgelegt ist, und damit die optischen Elemente E1 bis E5 als Linsenelemente ausgebildet sind. Das Projektionsobjektiv 10 gemäß Fig. 9 umfasst analog zur Ausführungsform gemäß Fig. 1 drei optische Module M1, M2' und M3, wobei das Modul M1 die optischen Elemente E1 und E2, das Modul M2' im vorliegenden Fall lediglich das optische Element E3 und das Modul M3 die optischen Elemente E4 und E5 enthalten. In weiteren Ausführungsvarianten kann das Modul M2' auch mehrere optische Elemente enthalten. Jedes der Module M1, M2' und M3 stellt eine optische Einheit des Projektionsobjektivs 10 dar. Dabei werden die Module M1 und M3 jeweils durch eine Teilanordnung der optischen Elemente E1 bis E5 des Projektionsobjektivs 10 und das Modul M2' durch lediglich das optische Element E3 gebildet.

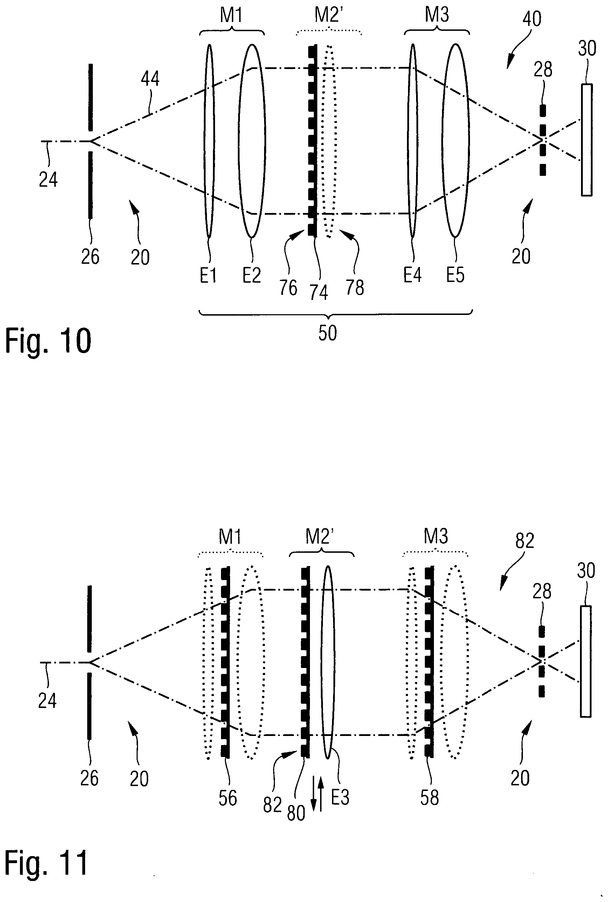

Neben einer Vermessung der einzelnen Module M1, M2' und M3 analog zu den Ausführungsformen gemäß der Figuren 3 bis 8 kommt auch eine Vermessung einer Kombination der von Modulen, wie etwa der Module M1 und M3 in Betracht, wie in der in Fig. 10 enthaltenen Messanordnung 40 dargestellt. In dieser Ausführungsvariante wird das Modul M2' in Gestalt des optischen Elements E3 aus dem Projektionsobjektiv 10 gemäß Fig. 9 entfernt, sodass die verbleibenden Module M1 und M3 eine durch eine Teilanordnung der optischen Elemente E1 bis E5, bei der anstelle des optischen Elements E3 eine Lücke 78 vorliegt, gebildete optische Einheit darstellen. Im Bereich der Lücke 78 wird ein der optischen Funktion des Moduls M2' in Gestalt des optischen Elements E3 entsprechendes Anpassungsmodul 74 angeordnet. Das Anpassungsmodul 74 enhält ein in Transmission betriebenes CGH mit einem diffraktiven Strukturmuster 76. Die durch das Modul M1, das Anpassungsmodul 74 sowie das Modul M3 gebildete optische Anordnung 50 wird mittels der Wellenfrontmessvorrichtung 20 gemäß Fig. 2 vermessen. Mit dieser Messung lässt sich der Wellenfrontfehler der durch die Kombination der Module M1 und M3 gebildeten Teilanordnung aus den optischen Elementen E1, E2, E4 und E5 sehr genau bestimmen.

Mit den beschriebenen Ausführungsbeispielen für eine Messanordnung und ein Verfahren lässt sich nacheinander eine Vermessung aller optischen Module eines abbildenden optischen Systems, beispielsweise in Gestalt des Projektionsobjektivs 10, und/oder eine Vermessung verschiedener Kombinationen optischer Module analog Fig. 10, bzw. allgemein eine Vermessung unterschiedlicher Teilanordnungen der optischen Elemente des abbildenden optischen Systems, durchführen. Gemäß einer Ausführung der Erfindung umfasst eines der beschriebenen Verfahren ein Bestimmen von Wellenfrontfehlern eines gesamten abbildenden optischen Systems auf Grundlage der für jede Teilanordnung, insbesondere der für jedes Modul des optischen Systems, bestimmten Wellenfrontfehler. Analog umfasst ein Ausführungsbeispiel einer Messanordnung eine entsprechend ausgebildete Auswertungseinrichtung zur Bestimmung von Wellenfrontfehlern des abbildenden optischen Systems anhand der Messergebnisse für jede einzelne Teilanordnung des optischen Systems.

Fig. 11 veranschaulicht die Kalibrierung einer Anordnung zweier Anpassungsmodule. Es handelt sich bei den beiden Anpassungsmodulen um ein eingangsseitiges Anpassungsmodul 56 sowie ein ausgangsseitiges Anpassungsmodul 58 zur Vermessung des Messmoduls M2' des Projektionsobjektivs 10 gemäß Fig. 9. Das Messmodul M2' umfasst in der gezeigten Ausführungsform lediglich das optische Element E3. Die Messanordnung ist analog zur Messanordnung gemäß Fig. 6 aufgebaut. In der in Fig. 11 veranschaulichten Messanordnung ist das eingangsseitige Anpassungsmodul 56 als CGH mit der optischen Funktion des Moduls M1 und das ausgangsseitige Anpassungsmodul 58 als CGH mit der optischen Funktion des Moduls M3 konfiguriert. Vor dem Messvorgang wird zunächst die Anordnung der beiden Anpassungsmodule 56 und 58 kalibriert.

Dazu wird eine Kalibriereinheit 80, welche die optische Funktion der zu vermessenden optischen Einheit in Gestalt des optischen Moduls M2' aufweist, anstelle des optischen Moduls M2' im Strahlengang 44 zwischen den Anpassungsmodulen 56 und 58 angeordnet. Die Kalibriereinheit 80 ist als CGH mit einem diffraktiven Strukturmuster 82 konfiguriert. Die Kalibrieranordnung 82 aus dem eingangsseitigen Anpassungsmodul 56, der Kalibriereinheit 80 sowie dem ausgangsseitigen Anpassungsmodul 58 wird nun mittels der Wellenfrontmessvorrichtung 20 vermessen. Aus dem dabei ermittelten Wellenfrontfehler werden unter Berücksichtigung von vorbekannten Wellenfrontfehlern der Kalibriereinheit 80 die Wellenfrontfehler der Anordnung der beiden Anpassungsmodule 56 und 58 als Kalibrierergebnis bestimmt. Zur Vermessung des optischen Moduls M2' wird nun das Kalibriermodul 80 durch das Modul M2' ersetzt und der dabei ermittelte Wellenfrontfehler anhand des Kalibrierergebnisses korrigiert.

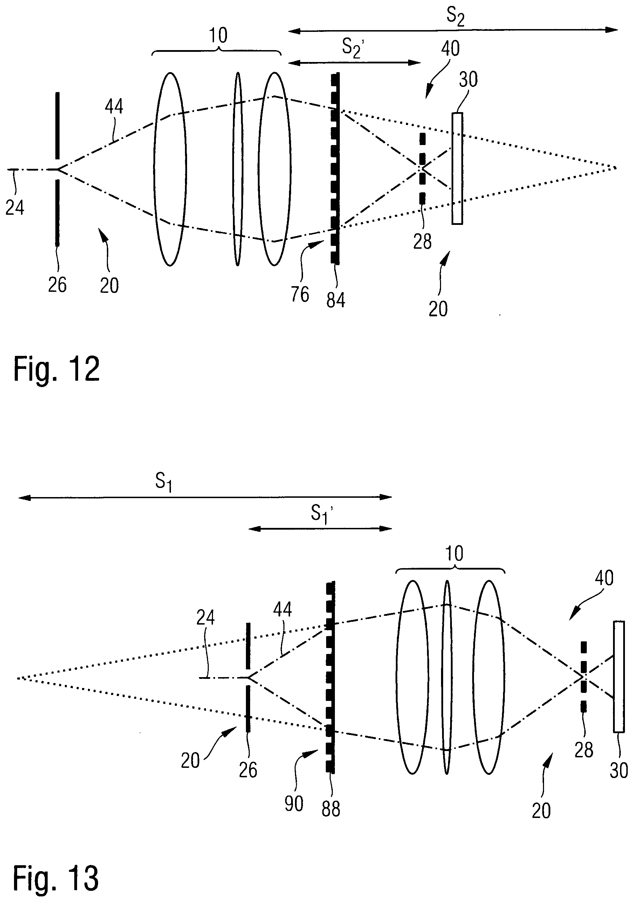

Die Figuren 12 und 13 veranschaulichen weitere Ausführungsformen einer Messanordnung 40. In diesem Ausführungsformen dient die Messanordnung 40 der Vermessung einer optischen Einheit in Gestalt eines abbildenden optischen Systems, wie z.B. eines Projektionsobjektivs 10 einer Projektionsbelichtungsanlage für die Mikrolithographie. Das in Fig. 12 dargestellte Projektionsobjektiv 10 ist durch eine sehr lange ausgangsseitige Schnittweite s₂ bzw. Brennweite in der Größenordnung von einigen Metern, wie z.B. sechs Metern, gekennzeichnet. Um den benötigen Bauraum für die Messanordnung 40 zu verringern, weist diese neben der Wellenfrontmessvorrichtung 20 ein dem Projektionsobjektiv 10 nachgeordnetes Anpassungsmodul 84 in Gestalt eines CGH mit einem diffraktiven Strukturmuster 86 auf. Das Anpassungsmodul 84 verkürzt die ausgangsseitige Schnittweite s₂ auf eine verringerte Schnittweite s₂' erheblich, insbesondere mindestens um den Faktor 2, 3 oder 4.

Analog dazu ist die Messanordnung 40 gemäß Fig. 13 dazu konfiguriert ein Projektionsobjektiv 10 zu vermessen, welches durch eine sehr lange eingangsseitige Schittweite s₁ bzw. Brennweite in der Größenordnung von einigen Metern gekennzeichnet ist. Zur Verrringerung des benötigten Bauraums für die Messanordung 40 weist diese ein dem Projektionsobjektiv 10 vorangestelltes Anpassungsmodul 88 in Gestalt eines CGH mit einem diffraktiven Strukturmuster 90 auf. Das Anpassungsmodul 88 verkürzt die eingangsseitige Schnittweite s₁ auf eine verringerte Schnittweite s₁' erheblich, insbesondere mindestens um den Faktor 2, 3 oder 4.

Die geometrische Form der diffraktiven Strukturmuster der verwendeten Anpassungsmodule in Gestalt von CGHs, wie etwa der Anpassungsmodule 74, 56, 58, 84 oder 88 gemäß der Figuren 10 bis 13, sind gemäß einer Ausführungsform an den jeweiligen am Einsatzort des Anpassungsmoduls vorliegenden Strahlquerschnitt der Messstrahlung 44 angepasst. So können die von den diffraktiven Strukturmustern beschriebenen Flächen z.B. eine kreisförmige, eine elliptische oder eine sichelförmige Gestalt aufweisen. Bei feldnah angeordneten Anpassungsmodule können für die einzelnen Feldpunkte jeweils eigene Flächenbereiche der o.g. Gestalt vorgesehen sein. Bei pupillennah angeordneten Anpassungsmodulen überlappen die den einzelnen Feldpunkten zugewiesenen Bereiche der diffraktiven Strukturmuster.

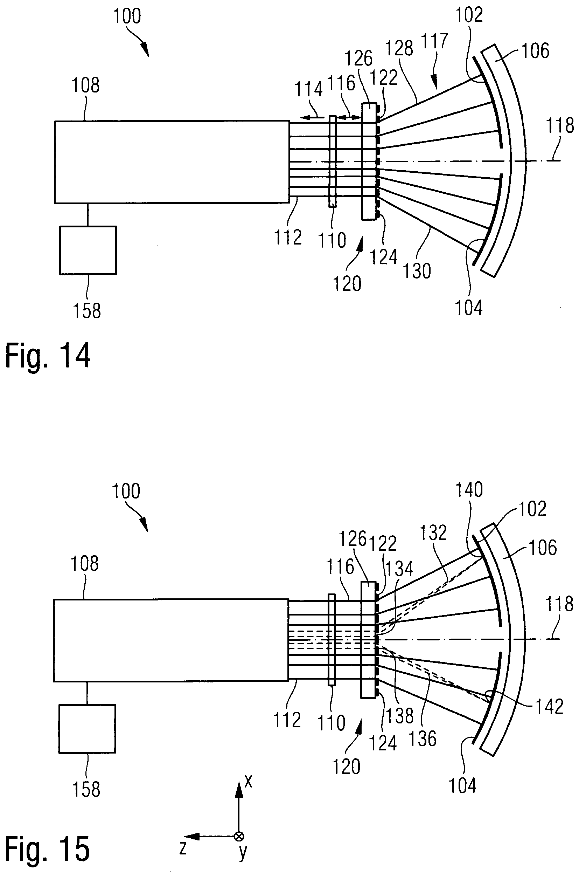

Die folgenden Figuren 14 bis 17 betreffen Ausführungsbeispiele einer Messvorrichtung und eines Verfahrens zur interferometrischen Formvermessung von optischen Oberflächen gemäß einem zweiten Aspekt der Erfindung. Die Ausführungsbeispiele einer Messvorrichtung werden jeweils zusammen mit Ausführungsbeispielen eines korrespondierenden Verfahrens beschrieben.

Fig. 14 stellt ein erstes Ausführungsbeispiel einer Messvorrichtung 100 zur interferometrischen Formvermessung von optischen Oberflächen dar. Insbesondere eignet sich die Messvorrichtung 100 zur gleichzeitigen Vermessung von mindestens zwei auf einem gemeinsamen Substrat 106 nebeneinander angeordneten optischen Oberflächen 102 und 104. Neben einer Abweichung der tatsächlichen Form der jeweiligen Oberfläche 102 bzw. 104 von einer Sollform lässt sich auch die relative räumliche Lage der Oberflächen 102 und 104 zueinander bestimmen. Die auf demselben Substrat 106 angeordneten optischen Oberflächen 102 und 104 können beispielsweise die Funktion zweier Spiegelelemente eines Projektionsobjektivs einer Projektionsbelichtungsanlage für die EUV-Mikrolithographie übernehmen.

Die Messvorrichtung 100 enthält ein Interferometer 108 mit einem Fizeau-Element 110. Der Aufbau und die Funktionsweise eines solchen Fizeau-Interferometers sind dem Fachmann bekannt. Insbesondere umfasst das Interferometer 108 eine Strahlungsquelle zur Erzeugung einer für eine interferometrische Messung ausreichend kohärenten elektromagnetischen Beleuchtungsstrahlung 112. Dazu kann beispielsweise ein Laser, z.B. ein Helium-Neon-Laser mit einer Wellenlänge von etwa 633 nm vorgesehen sein. Die Beleuchtungsstrahlung 112 kann auch eine andere Wellenlänge im sichtbaren oder nicht sichtbaren Wellenlängenbereich elektromagnetischer Strahlung aufweisen.

Die Beleuchtungsstrahlung 112 wird beispielsweise durch einen Kollimator zu einem kollimierten Strahl mit einer im Wesentlichen ebenen Wellenfront ausgebildet. In alternativen Ausführungen kann auch ein divergenter oder konvergenter Strahl mit einer sphärischen Wellenfront erzeugt werden. Der kollimierte Strahl trifft auf das Fizeau-Element 110. Von einer Fizeau-Fläche des Fizeau-Elements 110 wird ein Anteil der Beleuchtungsstrahlung in Form einer Referenzwelle 114 zurückreflektiert. Ein das Fizeau-Element 110 durchlaufender Anteil der Beleuchtungsstrahlung 112 breitet sich als Prüfstrahlung 116 weiter entlang der optischen Achse 118 des Interferometers 108 aus und trifft auf ein Wellenformelement 120 auf. Mittels des Wellenformelements 120 wird aus auftreffender Prüfstrahlung 116 eine Messstrahlung 117 erzeugt wird, welche sich aus zwei Messwellen 128 und 130 zusammensetzt. Nach einer Wechselwirkung mit den im Strahlengang der Messwellen 128 und 130 angeordneten optischen Oberflächen 102 bzw. 104 und anderen im Strahlengang vorgesehenen optischen Elementen läuft die Messstrahlung 117 durch das Fizeau-Element 110 in das Interferometer 108 zurück und wird dort mit der Referenzwelle 114 überlagert. Ein dadurch bei einer Erfassungsebene erzeugtes Interferogramm wird beispielsweise durch einen CCD-Sensor einer Interferometerkamera erfasst. In alternativen Ausführungsbeispielen kann als Interferometer auch ein Michelson-, ein Twyman-Green-Interferometer oder ein anderer geeigneter Interferometertyp verwendet werden.

Das Wellenformelement 120 enthält eine erste diffraktive Struktur 122 und eine zweite diffraktive Struktur 124, und ist in diesem Ausführungsbeispiel als ein CGH 126 ausgebildet. Dabei sind die erste und die zweite diffraktive Struktur 122, 124 in einer Ebene nebeneinander in dem CGH 126 angeordnet. In alternativen Ausführungen können auch mehr als zwei diffraktive Strukturen nebeneinander in einer Ebene eines CGHs angeordnet oder ein komplex kodiertes CGH mit zwei oder mehr in einer Ebene einander überlagernd angeordnete diffraktive Strukturen als Wellenformelement vorgesehen sein.

Die erste diffraktive Struktur 122 ist derart konfiguriert, dass sie aus einem Anteil der auftreffenden Prüfstrahlung 116 eine auf die erste optische Oberfläche 102 gerichtete erste Messwelle 128 mit einer an eine Sollform der ersten Oberfläche 102 angepassten Wellenfront erzeugt. Entsprechend ist die zweite diffraktive Struktur 124 zur Erzeugung einer auf die zweite optische Oberfläche 104 gerichteten zweiten Messwelle 130 in Form einer Messwelle mit einer an eine Sollform der zweiten Oberfläche 104 angepassten Wellenfront aus einem anderen Anteil der auf das Wellenformelement 120 auftreffenden Prüfstrahlung 116 ausgebildet.

Dabei erfolgt die Anpassung der Wellenfronten derart, dass die Wellenfronten der Messwellen 128 und 130 jeweils am Ort der optischen Oberflächen 102 und 104 der jeweiligen Sollform der Oberflächen 102 und 104 entsprechen. Auf diese Wiese wird für die erste und die zweite optische Oberfläche 102 bzw. 104 jeweils eine Nulloptik realisiert, bei der eine Oberfläche in Sollform die Messwelle 128 bzw. 130 in sich zurückreflektieren würde. Zur gleichzeitigen Vermessung von mehr als zwei Oberflächen können in weiteren Ausführungen der Messvorrichtung zusätzliche diffraktive Strukturen auf dem CGH 126 oder einem komplex kodierten CGH vorgesehen sein, welche jeweils zu einer entsprechenden Anpassung der Messstrahlung 117 für eine weitere optische Oberfläche konfiguriert sind.

Das Substrat 106 mit den zu vermessenden optischen Oberflächen 102 und 104 wird mittels einer nicht dargestellten Haltevorrichtung im Strahlengang der Prüfstrahlung 116 angeordnet. Von den optischen Oberflächen 102 und 104 wird die jeweilige Messwelle 128 bzw. 130 zurückreflektiert, durchläuft wiederum das einstückige Wellenformelement 120 und wird anschließend in dem Interferometer 108 durch Überlagerung mit der Referenzwelle 114 vermessen. Dabei entsteht in einer Erfassungsebene für jede der Oberflächen 102 und 104 bei einer Abweichung von der jeweiligen Sollform ein Interferogramm, welches beispielsweise von einem CCD-Sensor einer nicht dargestellten Interferometerkamera erfasst wird.

Neben einer gleichzeitigen Formvermessung der beiden optischen Oberflächen 102 und 104 erfolgt durch die Messvorrichtung 100 zusätzlich eine Vermessung der relativen Positionierung der optischen Oberflächen 102 und 104 zueinander. Diese wird nachstehend mit Bezug auf Fig. 15 näher beschrieben. Mit einer Auswerteeinrichtung 158 erfolgt schließlich eine Bestimmung der jeweiligen Form der Oberflächen 102 und 104 sowie deren relativen Lage zueinander. Dafür verwendet die Auswerteeinrichtung 158 die erfassten Interferogramme und einen gemessenen relativen Positionswert der optischen Oberflächen 102 und 104 zueinander für mindestens einen Starrkörperfreiheitsgrad. Alternativ kann auch eine Speicherung der erfassten Interferogramme und des Positionswerts für eine spätere Auswertung oder eine Übermittlung an eine externe Auswerteeinrichtung erfolgen.

Fig. 15 zeigt das Ausführungsbeispiel nach Fig. 14 mit Hilfswellen 132 und 136 zur nBestimmung einer relativen Position der optischen Oberflächen 102 und 104 zueinader. Zur Erzeugung einer ersten Hilfswelle 132 ist in dem CGH 126 des Wellenformelements 120 neben den diffraktiven Strukturen 122 und 124 eine erste Hilfsmessstruktur 134 angeordnet. Die erste Hilfsmessstruktur 134 enthält ein diffraktives Strukturmuster, welches derart konfiguriert ist, dass es aus einem Anteil der auftreffenden Prüfstrahlung 116 die auf einen Sollpunkt 140 der ersten Oberfläche 102 fokussierte erste Hilfswelle 132 erzeugt.

Weiterhin ist in dem CGH 126 neben den diffraktiven Strukturen 122 und 124 und der ersten Hilfsmessstruktur 134 eine zweite Hilfsmessstruktur 138 angeordnet. Die zweite Hilfsmessstruktur 138 enthält ein diffraktives Strukturmuster, welches derart ausgebildet ist, dass es aus einem Anteil der auftreffenden Prüfstrahlung 116 eine auf einen Sollpunkt 142 der zweiten Oberfläche 104 fokussierte zweite Hilfswelle 136 erzeugt.

Nach einer Rückreflexion der Hilfswellen 132 und 136 bei den jeweiligen Punkten 140 und 142 der optischen Oberflächen 102 und 104 werden diese in dem Interferometer 108 durch Überlagerung mit der Referenzwelle 114 interferometrisch vermessen. Mit Hilfe der Auswerteeinheit wird sehr genau eine Abweichung der optischen Oberfläche 102 bzw. 104 am jeweiligen Punkt 140 bzw. 142 von dem Sollfokuspunkt vermessen. Zusammen mit den durch die Hilfsmessstrukturen 134 und 138 jeweils festgelegten Winkeln zwischen der optischen Achse 118 des Interferometers 108 und den Ausbreitungsrichtungen der Hilfswellen 132 und 136 wird beispielsweise die relative z-Koordinate der optischen Oberflächen 102 und 104 zueinander bezüglich der Punkte 140, 142 bestimmt. Die z-Achse des die relative Lage der Oberflächen 102, 104 zueinander beschreibenden Koordinatensystems ist hier parallel zur optischen Achse 118 bzw. im Wesentlichen parallel zur mittleren Ausbreitungsrichtung der Messstrahlung 117 und damit quer zu den optischen Oberflächen 102 und 104 angeordnet. Eine Bestimmung der relativen x-Koordinate, y- Koordinate und der Kippkoordinaten der beiden optischen Oberflächen 102 und 104 zueinander erfolgt dann durch Auswertung der vermessenen reflektierten Messwellen der Oberflächenvermessung bzw. der ermittelten Formen der Oberflächen 102 und 104 unter Berücksichtigung der bekannten relativen z-Koordinate.

In anderen Ausführungen der Messvorrichtung 100 können zusätzliche Hilfsmessstrukturen für Hilfswellen auf dem Wellenformelement vorgesehen sein, um so eine Abweichung von weiteren Punkten der optischen Oberflächen von einem Sollfokus zu bestimmen. Ferner können zusätzlich ebene oder sphärische Justagestrukturen neben den optischen Oberflächen auf dem Substrat angeordnet sein, welche mit Hilfe von Hilfswellen mit ebener oder sphärischer Wellenfront in ihrer räumlichen Position vermessen werden.

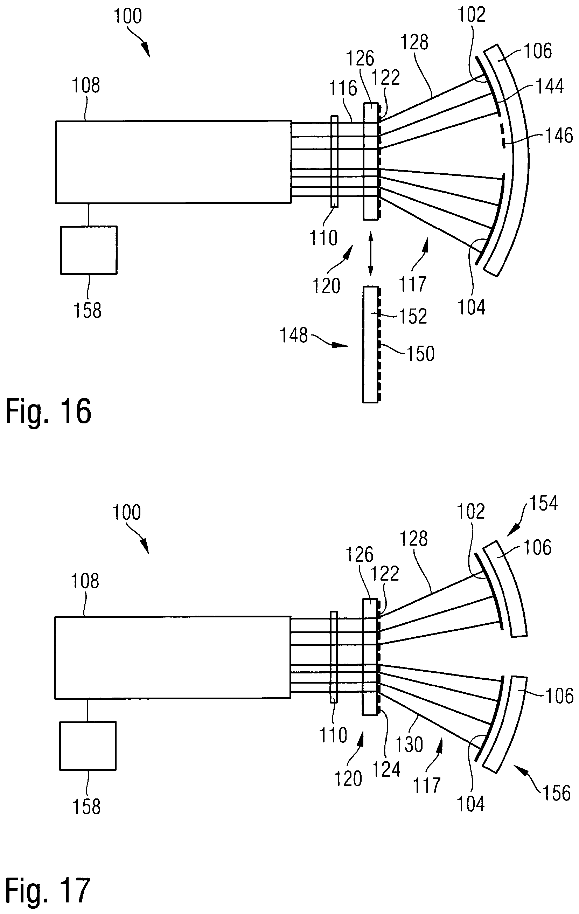

Fig. 16 zeigt ein weiteres Ausführungsbeispiel einer Messvorrichtung 100 zur gleichzeitigen Formvermessung von nebeneinander angeordneten optischen Oberflächen 102 und 104. Die Messvorrichtung 100 entspricht im Wesentlichen der Messvorrichtung nach Fig. 14 und Fig. 15. Im Gegensatz zu dieser ist die erste diffraktive Struktur 122 des CGHs 126 des Wellenformelements 120 derart konfiguriert, dass sie aus einem Anteil der Messstrahlung 116 eine nur auf einen ersten Teilbereich 144 der ersten optischen Oberfläche 102 gerichtete Messwelle 128 mit einer an eine Sollform des ersten Teilbereichs 144 angepassten Wellenfront erzeugt.

Zur Vermessung eines zweiten Teilbereichs 146 der ersten optischen Oberfläche 102 ist ein weiteres Wellenformelement 148 mit einer entsprechend konfigurierten diffraktiven Struktur 150 in einem CGH 152 vorgesehen. Zur Vermessung des zweiten Teilbereichs 146 erfolgt nach einer Vermessung des ersten Teilbereichs 144 und der zweiten optischen Oberfläche 104 mittels des ersten Wellenformelements 120 ein Austausch der Wellenformelemente 120 und 148 in der Messvorrichtung 100. Dazu kann die Messvorrichtung 100 eine nicht dargestellte Austauschvorrichtung enthalten. Anschließend wird eine Vermessung des zweiten Teilbereichs 146 mittels des zweiten Wellenformelements 148 durchgeführt. Ein Zusammensetzen der Teilmessung zu einer Gesamtmessung der optischen Oberfläche 102 erfolgt durch die Auswerteeinrichtung 158 mit einem so genannten Stitching-Verfahren oder einem anderen geeigneten Verfahren.

Auf diese Weise lassen sich auch Oberflächen vermessen, bei denen sich auf Grund der Form der Oberflächen die reflektierte Messstrahlung 116 zumindest teilweise kreuzt. In so einem Fall kann der entsprechende Abschnitt des Interferogramms nicht mehr der jeweiligen optischen Oberfläche zugeordnet werden. Durch eine nacheinander erfolgende Vermessung von Teilbereichen wird ein solches Ineinanderlaufen der reflektierten Messstrahlung verhindert.

Entsprechend kann auch ein Vermessen von zwei Teilbereichen der zweiten Oberfläche 104 oder ein Vermessen von mehr als zwei Teilbereichen der Oberflächen 102 und 104 nacheinander durch weitere Wellenformelemente vorgesehen sein. Alternativ oder zusätzlich zu einem Austausch von Wellenformelementen kann die Messvorrichtung auch eine Verschlusseinrichtung, z.B. mit einem oder mehreren Shuttern, enthalten, welche eine Messstrahlung nur für auswählbare Teilbereiche der Oberflächen passieren lässt. Bei einer solchen Ausführung kann das Wellenformelement für jeden Teilbereich eine diffraktive Struktur enthalten. Beispielsweise können auf einem CGH als Wellenformelement nebeneinander mehrere diffraktive Strukturen für jeweils einen Teilbereich einer Oberfläche vorgesehen sein.

In Fig. 17 wird das Ausführungsbeispiel der Messvorrichtung 100 nach Fig. 14 bei einer gleichzeitigen Vermessung einer optischen Oberfläche 102 eines ersten optischen Elements 154 und einer optischen Oberfläche 104 eines zweiten optischen Elements 156 dargestellt. Beide optischen Elemente 154 und 156 verfügen über ein eigenes Substrat 106 und sind mit einer nicht dargestellten Justagevorrichtung in ihrer räumlichen Lage zueinander justierbar fixiert. Dabei sind die optischen Oberflächen 102 und 104 nebeneinander im Strahlengang der die Messwellen 128 und 130 umfassenden Messstrahlung 117angeordnet. Zusammen mit der Justagevorrichtung stellen die beiden optischen Elemente 154 und 156, ähnlich wie die Kombination aus Substrat mit den beiden optischen Oberflächen 102 und 104 gemäß Fig. 14, ein zu vermessendes Gesamtmodul dar. Beispielsweise sind die optischen Elemente 154 und 156 zwei nebeneinander angeordnete Grazing-Incidence-Spiegel (G-Spiegel) für ein Projektionsobjektiv oder ein Beleuchtungssystem einer Projektionsbelichtungsanlage der EUV-Mikrolithographie. G-Spiegel sind Spiegel, die unter streifendem Einfall, d.h. unter einem flachen Einfallswinkel, angestrahlt werden. Unter einem flachen Einfallswinkel ist in diesem Zusammenhang ein Einfallswinkel zu verstehen, welcher mindestens 45°, insbesondere mindestens 60° oder mindestens 70°, gegenüber einer Oberflächennormalen des bestrahlten Spiegels abweicht. Mit der Messvorrichtung 100 nach Fig. 14 oder einer anderen oben beschriebenen Messvorrichtung ist gleichzeitig eine Vermessung beider Oberflächen 102 und 104 und der relativen Positionierung der Oberflächen 102 und 104 zueinander durchführbar.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen, insoweit sie in den Rahmen der Erfindung gemäß der Definition in den beigefügten Ansprüchen fallen, sowie Äquivalente vom Schutz der Ansprüche abgedeckt sein.

### Bezugszeichenliste

- 10: Projektionsobjektiv
- 12: Retikel
- 14: Wafer
- 16: Strahlengang
- E1-E6: Spiegel
- M1, M2, M2',M3: optische Module
- 20: Wellenfrontmessvorrichtung
- 22: abbildende Optik
- 24: Messstrahlung
- 26: Lochblende
- 28: Schergitter
- 30: Detektor
- 32: Erfassungsebene
- 40: Messanordnung
- 42: Anpassungsmodul
- 44: Strahlengang
- 46: CGH
- 48: diffraktives Strukturmuster
- 50: abbildende optische Anordnung
- 52, 54: CGHs in Refexion
- 56: eingangsseitiges Anpassungsmodul
- 58: ausgangsseitiges Anpassungsmodul
- 60, 62: CGHs in Transmission
- 64, 66: komplex kodierte CGHs
- 68: zweite Lochblende
- 70: überlagerte diffraktive Strukturen
- 72: Messstrahlung
- 74: Anpassungsmodul
- 76: diffraktives Strukturmuster
- 78: Lücke
- 80: Kalibriereinheit
- 82: diffraktives Strukturmuster
- 84: Anpassungsmodul
- 86: diffraktives Strukturmuster
- 88: Anpassungsmodul
- 90: diffraktives Strukturmuster
- 92: Kalibrieranordnung
- 100: Messvorrichtung
- 102: erste optische Oberfläche
- 104: zweite optische Oberfläche
- 106: Substrat
- 108: Interferometer
- 110: Fizeau-Element
- 112: Beleuchtungsstrahlung
- 114: Referenzwelle
- 116: Prüfstrahlung
- 117: Messstrahlung
- 118: optische Achse
- 120: Wellenformelement
- 122: erste diffraktive Struktur
- 124: zweite diffraktive Struktur
- 126: CGH
- 128: erste Messwelle
- 130: zweite Messwelle
- 132: erste Hilfswelle
- 134: erste Hilfsmessstruktur
- 136: zweite Hilfswelle
- 138: zweite Hilfsmessstruktur
- 140: Punkt von erster Oberfläche
- 142: Punkt von zweiter Oberfläche
- 144: erster Teilbereich
- 146: zweiter Teilbereich
- 148: zweites Wellenformelement
- 150: diffraktive Struktur
- 152: CGH
- 154: erstes optisches Element
- 156: zweites optisches Element
- 158: Auswerteeinrichtung

## Patentansprüche

1. Messanordnung (40) zur Vermessung einer optischen Einheit (M1; M2; M3; M1, M3, 10) einer Projektionsbelichtungsanlage für die Mikrolithographie mit:
- einer Wellenfrontmessvorrichtung (20), welche dazu konfiguriert ist mittels phasenschiebender Interferometrie einen Wellenfrontfehler einer abbildenden Optik (22) mittels einer Messstrahlung (72) zu vermessen und welche eine Lochblende oder eine Kohärenzmaske sowie ein Schergitter aufweist, sowie
- mindestens einem Anpassungsmodul (42; 56, 58; 84), welches zur derartigen Manipulation der Wellenfront der Messstrahlung konfiguriert ist, dass die Kombination aus der zu vermessenden optischen Einheit und dem mindestens einen Anpassungsmodul eine abbildende optische Anordnung (50) bildet, welche eine Öffnung der Lochblende oder die Kohärenzmaske auf das Schergitter abbildet,
wobei die Messanordnung weiterhin dazu konfiguriert ist, aus einem mittels der Wellenfrontmessvorrichtung vermessenen Wellenfrontfehler der aus der Kombination gebildeten abbildenden optischen Anordnung durch ein Herausrechnen eines vorbekannten Wellenfrontfehlers des Anpassungsmoduls (42; 56; 58; 84) einen Wellenfrontfehler der zu vermessenden optischen Einheit zu bestimmen.

2. Messanordnung nach Anspruch 1,
bei der die optische Einheit einem mehrere optische Elemente umfassenden abbildenden optischen System (10) einer Projektionsbelichtungsanlage für die Mikrolithographie zugeordnet ist, und die optische Einheit durch eines der optischen Elemente des abbildenden optischen Systems, durch eine Teilanordnung (M1; M2; M3; M1, M3) der optischen Elemente des abbildenden optischen Systems (10) oder durch das abbildende optische System (10) gebildet ist.

3. Messanordnung nach Anspruch 2,
bei der die optische Einheit durch eine Teilanordnung der optischen Elemente des abbildenden optischen Systems gebildet ist, wobei die Teilanordnung der optischen Elemente sich von mindestens einem Abschnitt des abbildenden optischen System durch das Vorliegen einer mindestens ein optisches Element betreffenden Lücke (78) unterscheidet.

4. Messanordnung nach einem der vorausgehenden Ansprüche,
bei der das Anpassungsmodul dazu konfiguriert ist, eine Schnittweite der zu vermessenden optischen Einheit (10) zu verkürzen.

5. Messanordnung nach einem der vorausgehenden Ansprüche,
welche weiterhin eine die optische Funktion der zu vermessenden optischen Einheit aufweisende Kalibriereinheit (80) aufweist, welche dazu konfiguriert ist, vor der Vermessung der optischen Einheit das mindestens eine Anpassungsmodul (56, 58) durch Bestimmung eines Wellenfrontfehlers einer das mindestens eine Anpassungsmodul sowie die Kalibriereinheit umfassenden Anordnung zu kalibrieren.

6. Messanordnung nach einem der vorausgehenden Ansprüche,
wobei das mindestens eine Anpassungsmodul ein oder mehrere in Reflexion oder in Transmission betriebene diffraktive Strukturen aufweist.

7. Messanordnung nach einem der vorausgehenden Ansprüche ,
wobei das mindestens eine Anpassungsmodul mindestens zwei in einem Strahlengang der Messstrahlung einander überlagernd oder hintereinander angeordnete diffraktive Strukturmuster (70) enthält.

8. Verfahren zum Vermessen einer optischen Einheit (M1; M2; M3; M1, M3, 10) eines Projektionsobjektivs (10) einer Projektionsbelichtungsanlage für die Mikrolithographie mit den Schritten:
- derartiges Anordnen mindestens eines Anpassungsmoduls (42; 56, 58; 84) an der zu vermessenden optischen Einheit, dass die Kombination aus der zu vermessenden optischen Einheit und dem mindestens einen Anpassungsmodul eine abbildende optische Anordnung (50) bildet, welche eine Öffnung einer Lochblende oder eine Kohärenzmaske auf ein Schergitter abbildet,
- Vermessen eines Wellenfrontfehlers der aus der Kombination gebildeten abbildenden optischen Anordnung mittels phasenschiebender Interferometrie, sowie
- Bestimmen eines Wellenfrontfehlers der zu vermessenden optischen Einheit aus dem vermessenen Wellenfrontfehler der aus der Kombination gebildeten optischen Anordnung durch ein Herausrechnen eines vorbekannten Wellenfrontfehlers des Anpassungsmoduls (42; 56; 58; 84).

9. Verfahren nach Anspruch 8,
bei dem die zu vermessende optische Einheit als nicht-abbildende Optik konfiguriert ist, welche bei Einstrahlung einer ebenen oder einer sphärischen Eingangswelle mit einer Wellenlänge λ eine Ausgangswelle generiert, deren Wellenfront an mindestens einem Punkt mindestens λ von einer idealen Kugelwelle abweicht.

10. Verfahren zum Vermessen eines Wellenfrontfehlers eines abbildenden optischen Systems (10) einer Projektionsbelichtungsanlage für die Mikrolithographie mit mehreren optischen Elementen (E1-E6) zum Abbilden eines Musters aus einer Objektebene in eine Bildebene,
wobei jeweilige Wellenfrontfehler unterschiedlicher Teilanordnungen (M1; M2; M3; M1, M3) der optischen Elemente separat vermessen werden.

11. Verfahren nach Anspruch 10,
wobei eine der Teilanordnungen der optischen Elemente sich von mindestens einem Abschnitt des abbildenden optischen Systems durch das Vorliegen einer mindestens ein optisches Element betreffenden Lücke (78) unterscheidet.

12. Verfahren nach Anspruch 10 oder 11,
wobei das abbildende optische System mit mehreren, jeweils mindestens zwei der optischen Elemente umfassenden, optischen Modulen bereitgestellt wird und das separate Vermessen der jeweiligen Wellenfrontfehler unterschiedlicher Teilanordnungen durch ein separates Vermessen jeweiliger Wellenfrontfehler der einzelnen optischen Module (M1; M2; M3) erfolgt.

13. Verfahren nach einem der Ansprüche 10 bis 12,
bei dem die Vermessung einer der Teilanordnungen ein derartiges Anordnen der zu vermessenden Teilanordnung und mindestens eines Anpassungsmoduls im Strahlengang einer Messstrahlung (72) einer Wellenfrontmessvorrichtung (20) umfasst, dass die Kombination aus der zu vermessenden Teilanordnung und dem mindestens einen Anpassungsmodul eine abbildende optische Anordnung (50) bildet, und die Vermessung weiterhin eine Bestimmung des Wellenfrontfehlers der abbildenden optischen Anordnung mittels der Wellenfrontmessvorrichtung umfasst.

14. Verfahren nach Anspruch 13,
bei dem das Anordnen des mindestens einen Anpassungsmoduls ein Anordnen eines eingangsseitigen Anpassungsmoduls (56) zum Manipulieren der Messstrahlung vor der zu vermessenden Teilanordnung, und ein Anordnen eines ausgangsseitigen Anpassungsmoduls (58) zum Manipulieren der Messstrahlung nach der zu vermessenden Teilanordnung umfasst.

15. Verfahren nach Anspruch 13 oder 14,
bei dem in dem mindestens einen Anpassungsmodul mindestens ein diffraktives Strukturmuster (48) zur Manipulation der Wellenfront der Messstrahlung verwendet wird.

## Claims

1. A measurement arrangement (40) for measuring an optical unit (M1; M2; M3; M1, M3, 10) of a microlithographic projection exposure apparatus, comprising:
- a wavefront measurement apparatus (20) which is configured to measure, by means of phase-shifting interferometry, a wavefront aberration of imaging optics (22) by means of measurement radiation (72) and which comprises a pinhole or a coherence mask and a shearing grating, and
- at least one adaptation module (42; 56, 58; 84) which is configured for such manipulation of the wavefront of the measurement radiation that the combination of the optical unit to be measured and the at least one adaptation module forms an imaging optical arrangement (50) which images an opening of the pinhole or the coherence mask on the shearing grating,
wherein the measurement arrangement is furthermore configured to determine a wavefront aberration of the optical unit to be measured by removing an already known wavefront aberration of the adaptation module (42; 56; 58; 84) from a wavefront aberration, measured by means of the wavefront measurement apparatus, of the imaging optical arrangement formed by the combination.

2. The measurement arrangement according to Claim 1,
wherein the optical unit is assigned to an imaging optical system (10), comprising a plurality of optical elements, of a microlithographic projection exposure apparatus, and the optical unit is formed by one of the optical elements of the imaging optical system, by a partial arrangement (M1; M2; M3; M1, M3) of the optical elements of the imaging optical system (10) or by the imaging optical system (10).

3. The measurement arrangement according to Claim 2,
wherein the optical unit is formed by a partial arrangement of the optical elements of the imaging optical system, wherein the partial arrangement of the optical elements differs from at least one section of the imaging optical system by the presence of a gap (78) that relates to at least one optical element.

4. The measurement arrangement according to any of the preceding claims,
wherein the adaptation module is configured to shorten a back focal length of the optical unit (10) to be measured.

5. The measurement arrangement according to any of the preceding claims,
furthermore comprising a calibration unit (80) having the optical function of the optical unit to be measured, said calibration unit being configured to calibrate the at least one adaptation module (56, 58) before measuring the optical unit, the calibration being carried out by determining a wavefront aberration of an arrangement comprising the at least one adaptation module and the calibration unit.

6. The measurement arrangement according to any of the preceding claims,
wherein the at least one adaptation module has one or more diffractive structures that are operated in reflection or in transmission.

7. The measurement arrangement according to any of the preceding claims,
wherein the at least one adaptation module contains at least two diffractive structure patterns (70) that are superposed on one another, or arranged in succession, in a beam path of the measurement radiation.

8. A method for measuring an optical unit (M1; M2; M3; M1, M3, 10) of a projection lens (10) of a microlithographic projection exposure apparatus, comprising the following steps:
- arranging at least one adaptation module (42; 56, 58; 84) on the optical unit to be measured, in such a way that the combination of the optical unit to be measured and the at least one adaptation module forms an imaging optical arrangement (50) which images an opening of a pinhole or a coherence mask on a shearing grating,
- measuring, by means of phase-shifting interferometry, a wavefront aberration of the imaging optical arrangement formed by the combination, and
- determining a wavefront aberration of the optical unit to be measured by removing an already known wavefront aberration of the adaptation module (42; 56; 58; 84) from the measured wavefront aberration of the optical arrangement formed by the combination.

9. The method according to Claim 8,
wherein the optical unit to be measured is configured as non-imaging optics, which, if a plane or spherical input wave with a wavelength λ is radiated thereon, generate an output wave, the wavefront of which deviates by at least λ from an ideal spherical wave at at least one point.

10. A method for measuring a wavefront aberration of an imaging optical system (10) of a microlithographic projection exposure apparatus, comprising a plurality of optical elements (E1-E6) for imaging a pattern from an object plane into an image plane,
wherein respective wavefront aberrations of different partial arrangements (M1; M2; M3; M1, M3) of the optical elements are measured separately.

11. The method according to Claim 10,
wherein one of the partial arrangements of the optical elements differs from at least one section of the imaging optical system by the presence of a gap (78) that relates to at least one optical element.

12. The method according to Claim 10 or 11,
wherein the imaging optical system is provided with a plurality of optical modules that respectively comprise at least two of the optical elements, and the separate measurement of the respective wavefront aberrations of different partial arrangements is effectuated by a separate measurement of respective wavefront aberrations of the individual optical modules (M1; M2; M3).

13. The method according to any of Claims 10 to 12,
wherein the measurement of one of the partial arrangements comprises such arranging of the partial arrangement to be measured and of at least one adaptation module in the beam path of a measurement radiation (72) of a wavefront measurement apparatus (20) that the combination of the partial arrangement to be measured and the at least one adaptation module forms an imaging optical arrangement (50), and the measurement furthermore comprises determining the wavefront aberration of the imaging optical arrangement by means of the wavefront measurement apparatus.

14. The method according to Claim 13,
wherein arranging the at least one adaptation module comprises arranging an input-side adaptation module (56) for manipulating the measurement radiation upstream of the partial arrangement to be measured, and arranging an output-side adaptation module (58) for manipulating the measurement radiation downstream of the partial arrangement to be measured.

15. The method according to Claim 13 or 14,
wherein at least one diffractive structure pattern (48) for manipulating the wavefront of the measurement radiation is used in the at least one adaptation module.

## Revendications

1. Dispositif de mesure (40) pour mesurer une unité optique (M1 ; M2 ; M3 ; M1, M3, 10) d'un système d'exposition par projection pour la microlithographie, comprenant :
- un dispositif (20) de mesure de front d'onde qui est configuré pour mesurer, au moyen d'une interférométrie à décalage de phase, une aberration de front d'onde d'une optique (22) de formation d'image au moyen d'un rayonnement de mesure (72), et qui comprend un diaphragme à trou ou un masque de cohérence ainsi qu'un réseau de diffraction, et
- au moins un module d'adaptation (42 ; 56, 58 ; 84) qui est configuré pour manipuler le front d'onde du rayonnement de mesure de telle sorte que la combinaison de l'unité optique à mesurer et dudit au moins un module d'adaptation forme un ensemble optique de formation d'images (50) qui forme une image d'une ouverture du diaphragme à trou ou du masque de cohérence sur le réseau de diffraction,
le dispositif de mesure étant en outre configuré pour déterminer une aberration de front d'onde de l'unité optique à mesurer, à partir d'une aberration de front d'onde mesurée au moyen du dispositif de mesure de front d'onde de l'ensemble optique de formation d'image formé par la combinaison, en soustrayant une aberration de front d'onde connue au préalable du module d'adaptation (42 ; 56 ; 58 ; 84).

2. Dispositif de mesure selon la revendication 1,
dans lequel l'unité optique est associée à un système optique (10) de formation d'image comprenant plusieurs éléments optiques d'un dispositif d'exposition par projection pour la microlithographie, et l'unité optique étant déviée par l'un des éléments optiques du système optique de formation d'image, par un sous-ensemble (M1 ; M2 ; M3 ; M1, M3) des éléments optiques du système optique (10) de formation d'image ou par le système optique (10) de formation d'image.

3. Dispositif de mesure selon la revendication 2,
dans lequel l'unité optique est formée par un sous-ensemble des éléments optiques du système optique de formation d'image, le sous-ensemble des éléments optiques se distinguant d'au moins une partie du système optique de formation d'image par la présence d'un espace (78) concernant au moins un élément optique.

4. Dispositif de mesure selon l'une des revendications précédentes,
dans lequel le module d'adaptation est configuré de manière à raccourcir une distance focale de l'unité optique (10) à mesurer.

5. Dispositif de mesure selon l'une des revendications précédentes,
qui comprend en outre une unité d'étalonnage (80) comprenant la fonction optique de l'unité optique à mesurer, qui est configurée de manière à étalonner, avant la mesure de l'unité optique, ledit au moins un module d'adaptation (56, 58) en déterminant une aberration de front d'onde d'un agencement comprenant ledit au moins un module d'adaptation ainsi que l'unité d'étalonnage.

6. Dispositif de mesure selon l'une des revendications précédentes,
dans lequel ledit au moins un module d'adaptation comprend une ou plusieurs structures diffractives fonctionnant en réflexion ou en transmission.

7. Dispositif de mesure selon l'une des revendications précédentes,
dans lequel ledit au moins un module d'adaptation comprend au moins deux motifs de structure diffractive (70) superposés ou agencés l'un derrière l'autre dans un trajet de faisceau du rayonnement de mesure.

8. Procédé de mesure d'une unité optique (M1 ; M2 ; M3 ; M1, M3, 10) d'un objectif de projection (10) d'un dispositif d'exposition par projection pour la microlithographie, comprenant les étapes suivantes :
- agencer au moins un module d'adaptation (42 ; 56, 58 ; 84) sur l'unité optique à mesurer de telle sorte que la combinaison de l'unité optique à mesurer et dudit au moins un module d'adaptation forme un dispositif optique de formation d'image (50) qui forme une image d'une ouverture d'un diaphragme à trou ou d'un masque de cohérence sur un réseau de diffraction,
- mesurer, au moyen d'une interférométrie à décalage de phase, une aberration de front d'onde du dispositif optique de formation d'image formé par la combinaison, et
- déterminer une aberration de front d'onde de l'unité optique à mesurer à partir de l'aberration de front d'onde mesurée de l'ensemble optique formé par la combinaison, en soustrayant une aberration de front d'onde connue au préalable du module d'adaptation (42 ; 56 ; 58 ; 84).

9. Procédé selon la revendication 8,
dans lequel l'unité optique à mesurer est configurée sous la forme d'une optique non imageante qui, lors de l'incidence d'une onde d'entrée plane ou sphérique d'une longueur d'onde λ, génère une onde de sortie dont le front d'onde s'écarte d'au moins λ d'une onde sphérique idéale en au moins un point.

10. Procédé de mesure d'une aberration de front d'onde d'un système optique (10) de formation d'image d'une installation d'exposition par projection pour la microlithographie, comportant plusieurs éléments optiques (E1-E6) pour former l'image d'un motif à partir d'un plan objet dans un plan image,
les aberrations de front d'onde respectives de différents sous-ensembles (M1 ; M2 ; M3 ; M1, M3) des éléments optiques étant mesurées séparément.

11. Procédé selon la revendication 10,
dans lequel l'un des sous-ensembles des éléments optiques se distinguant d'au moins une partie du système optique de formation d'image par la présence d'un espace (78) concernant au moins un élément optique.

12. Procédé selon la revendication 10 ou la revendication 11,
dans lequel le système optique de formation d'image est pourvu d'une pluralité de modules optiques comprenant chacun au moins deux des éléments optiques, et la mesure séparée des erreurs de front d'onde respectives de différents sous-ensembles étant effectuée par une mesure séparée des erreurs de front d'onde respectives des différents modules optiques (M1 ; M2 ; M3).

13. Procédé selon l'une des revendications 10 à 12,
dans lequel la mesure d'un des sous-ensembles nécessite un agencement du sous-ensemble à mesurer et d'au moins un module d'adaptation dans le trajet du faisceau d' un rayonnement de mesure (72) d'un dispositif (20) de mesure de front d'onde, tel que la combinaison du sous-ensemble à mesurer et dudit au moins un module d'adaptation forme un ensemble optique de formation d'image (50), et la mesure comprend en outre une détermination de l'aberration de front d'onde de l'ensemble optique de formation d'image au moyen du dispositif de mesure de front d'onde.

14. Procédé selon la revendication 13,
dans lequel l'agencement dudit au moins un module d'adaptation comprend un agencement d'un module d'adaptation côté entrée (56) pour manipuler le rayonnement de mesure avant le sous-ensemble à mesurer, et un agencement d'un module d'adaptation côté sortie (58) pour manipuler le rayonnement de mesure après le sous-ensemble à mesurer.

15. Procédé selon la revendication 13 ou la revendication 14,
dans lequel au moins un motif structurel diffractif (48) est utilisé dans ledit au moins un module d'adaptation pour manipuler le front d'onde du rayonnement de mesure.
